# EUROPEAN PATENT SPECIFICATION

(11) **EP 3 399 554 B1**
(45) Date of publication and mention of the grant of the patent: **13.05.2020**
(21) Application number: 18161738.2
(22) Date of filing: 14.03.2018
(51) Int. Cl.: H01L 27/15

(54) **LIGHT EMITTING DIODE**
LICHTEMITTIERENDE DIODE
DIODE ÉLECTROLUMINESCENTE

(30) Priority: 14.03.2017 KR 20170032021; 24.07.2017 KR 20170093338
(43) Date of publication of application: 07.11.2018
(73) Proprietor: Seoul Viosys Co., Ltd, Ansan-si, Gyeonggi-do (KR)
(72) Inventor: OH, Se Hee, 00000 Gyeonggi-do (KR); KIM, Jong Kyu, 00000 Gyeonggi-do (KR); KIM, Hyun A, 00000 Gyeonggi-do (KR)
(74) Representative: Isarpatent

(56) References cited:
- EP-A2- 2 187 442
- WO-A1-2007/034367
- WO-A2-2009/019836
- US-A1- 2015 084 084
- US-A1- 2017 062 671

## Description

### PRIORITY CLAIMS AND CROSS-REFERENCE TO RELATED APPLICATION

This patent document claims priority to and the benefit of Korean Patent Application No. 10-2017-0032021, filed on March 14, 2017, and Korean Patent Application No. 10-2017-0093338 filed on July 24, 2017.

### TECHNICAL FIELD

Exemplary embodiments of the present disclosure relate to a light emitting diode package including a plurality of light emitting regions.

### BACKGROUND

A light emitting diode (LED) refers to a solid-state device that emits light through conversion of electric energy. The light emitting diode is broadly applied to various light sources for backlight units, lighting, signal boards, large displays, and the like.

A typical light emitting diode may include a plurality of light emitting cells. The typical light emitting diode has a structure wherein the plural light emitting cells are arranged in a transverse direction or in a longitudinal direction. Such a typical light emitting diode has difficulty efficiently controlling beam angle through drive control of the plural light emitting cells. In addition, since each of the light emitting cells has its own optical axis, it is difficult to use a monofocal lens in fabrication of a module including a lens. As a result, it is difficult to achieve miniaturization of the module and there is a problem of inefficiency in terms of economic feasibility.

In addition, such a typical light emitting diode may further include a wavelength conversion layer disposed on each of the light emitting cells. However, conventional arrangement of the plural light emitting cells makes it difficult to achieve efficient color combination of light emitted from each of the light emitting cells through the wavelength conversion layer and to achieve efficient control of color temperature. WO 2009/019836 A2, WO 2007/034367 A1, and EP 2 187 442 A2 relate to light emitting device of the prior art.

### SUMMARY

The invention is defined by the appended claims. Exemplary embodiments of the present disclosure provide a light emitting diode package including a plurality of light emitting regions having a common center.

Exemplary embodiments of the present disclosure provide a light emitting diode package capable of controlling a beam angle.

Exemplary embodiments of the present disclosure provide a light emitting diode package having improved heat dissipation efficiency.

Exemplary embodiments of the present disclosure provide a light emitting diode package capable of controlling color temperature.

In accordance with one exemplary embodiment of the present disclosure, a light emitting diode package according to claim 1 is provided.

### BRIEF DESCRIPTION OF DRAWINGS

FIG. 1 is a top plan view of a light emitting diode according to one exemplary embodiment of the present disclosure.
FIG. 2 is a cross-sectional view taken along line A-A' of FIG. 1.
FIG. 3 is a cross-sectional view taken along line B-B' of FIG. 1.
FIG. 4 is a cross-sectional view taken along line C-C' of FIG. 1.
FIG. 5 is a top plan view of a light emitting diode according to another exemplary embodiment of the present disclosure.
FIG. 6 is a cross-sectional view taken along line D-D' of FIG. 5.
FIG. 7 is a schematic circuit diagram illustrating an electrical connection relationship between first and second light emitting regions C1, C2 in the light emitting diode shown in FIG. 1 or FIG. 5.
FIG. 8 is a top plan view of a light emitting diode according to a further exemplary embodiment of the present disclosure.
FIG. 9 is a cross-sectional view taken along line E-E' of FIG. 8.
FIG. 10 is a cross-sectional view taken along line F-F' of FIG. 8.
FIG. 11 is a cross-sectional view taken along line G-G' of FIG. 8.
FIG. 12 is a schematic circuit diagram illustrating an electrical connection relationship between first and second light emitting regions C1, C2 in the light emitting diode shown in FIG. 8.
FIG. 13 to FIG. 15 are top plan views of light emitting diodes according to other exemplary embodiments of the present disclosure.
FIG. 16 to FIG. 18 are top plan views of light emitting diodes according to other exemplary embodiments of the present disclosure.
FIG. 19 is a perspective view of a light emitting diode package according to other exemplary embodiments of the present invention.
FIG. 20 to FIG. 22 are cross-sectional views taken along line I-I' of FIG. 19.

### DETAILED DESCRIPTION

Hereinafter, exemplary embodiments of the present disclosure will be described in detail with reference to the accompanying drawings. The following embodiments are provided by way of example so as to fully convey the invention to those skilled in the art to which the present disclosure pertains. Accordingly, the present disclosure is not limited to the embodiments disclosed herein and can also be implemented in different forms, within the scope of the appended claims. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

In the present description, "embodiments of the disclosure" are comparative examples useful for understanding the invention, which is defined by the appended claims.

In accordance with one exemplary embodiment of the present disclosure, a light emitting diode includes: first and second light emitting regions each including a first conductivity type semiconductor layer, a second conductivity type semiconductor layer and an active layer interposed between the first conductivity type semiconductor layer and the second conductivity type semiconductor layer; an ohmic reflective layer disposed on the second conductivity type semiconductor layer of each of the first and second light emitting regions; and a first pad metal layer separated from the ohmic reflective layer and electrically connected to the first conductivity type semiconductor layer of each of the first and second light emitting regions, wherein the second light emitting region surrounds the first light emitting region. That is, the first and second light emitting regions may have a common center such that the light emitting diode has a single optical axis.

The light emitting diode further includes a mesa trench disposed between the first light emitting region and the second light emitting region and exposing the first conductivity type semiconductor layer. The exposed first conductivity type semiconductor layer is connected to a first pad metal layer, as described below. The mesa trench has a closed loop structure surrounding the first light emitting region and surrounded by the second light emitting region.

The light emitting diode further includes a lower insulation layer covering the first and second light emitting regions and the ohmic reflective layer, wherein the first pad metal layer is disposed on the lower insulation layer.

The lower insulation layer includes a first opening exposing the first conductivity type semiconductor layer exposed through the mesa trench and second openings exposing the ohmic reflective layer, and the first pad metal layer is connected to the first conductivity type semiconductor layer through the first opening.

The light emitting diode may further include a second pad metal layer disposed on the lower insulation layer and connected to the ohmic reflective layers through the second openings.

The second pad metal layer may include a second-first pad metal layer connected to the ohmic reflective layer disposed in the first light emitting region and exposed through the second openings; and a second-second pad metal layer connected to the ohmic reflective layer disposed in the second light emitting region exposed through the second openings.

The second-second pad metal layer may be surrounded by the first pad metal layer in the second light emitting region.

The light emitting diode may further include a upper insulation layer covering the first and second pad metal layers and including third openings exposing the first and second pad metal layers.

The second openings and the third openings may be alternately arranged. With this structure, the light emitting diode can prevent contamination of the ohmic reflective layer by solders by preventing the solders from diffusing into the second openings of a lower insulation layer even when the solders enter the third openings of an upper insulating layer.

The light emitting diode may further include: a first bump pad connected to the first pad metal layer through at least one third opening; a second-first bump pad connected to the second-first pad metal layer through at least one third opening; and a second-second bump pad connected to the second-second pad metal layer through at least one third opening.

The light emitting diode may further include a support disposed under the first conductivity type semiconductor layer. The substrate can serve to support the first and second light emitting regions.

The light emitting diode may further include an isolation trench interposed between the first light emitting region and the second light emitting region and exposing the substrate. The first conductivity type semiconductor layer of the first and second light emitting regions may be divided by the isolation trench.

The isolation trench may include a closed loop structure surrounding the first light emitting region and surrounded by the second light emitting region.

The light emitting diode further includes a lower insulation layer covering the first and second light emitting regions, the ohmic reflective layer, and the substrate exposed through the isolation trench.

Each of the first and second light emitting regions includes a mesa etching region exposing the first conductivity type semiconductor layer.

The lower insulation layer includes at least one first opening exposing the first conductivity type semiconductor layer exposed in the mesa etching region and at least one second opening exposing the ohmic reflective layer in each of the first and second light emitting regions.

The first pad metal layer may include: a first-first pad metal layer connected to the first conductivity type semiconductor layer of the first light emitting region through the at least one first opening; and a first-second pad metal layer connected to the first conductivity type semiconductor layer of the second light emitting region through the at least one first opening.

The light emitting diode may further include a second pad metal layer disposed on the lower insulation layer and connected to the ohmic reflective layer through the at least one second opening.

The second pad metal layer may be commonly connected to the ohmic reflective layer of each of the first and second light emitting regions through the at least one second opening.

The light emitting diode may further include a upper insulation layer covering the first and second pad metal layers.

The upper insulation layer may include third openings exposing the first and second pad metal layers.

The light emitting diode may further include: a first-first bump pad connected to the first-first pad metal layer exposed through the third openings; a first-second bump pad connected to the first-second pad metal layer exposed through the third openings; and a second bump pad connected to the second pad metal layer exposed through the third openings.

The first light emitting region and the second light emitting region can be independently driven. The first and second light emitting regions have a common center and are independently driven, whereby the light emitting diode according to the exemplary embodiments can permit efficient control of beam angle.

In accordance with an exemplary embodiment of the invention, a light emitting diode package according to claim 1 is provided.

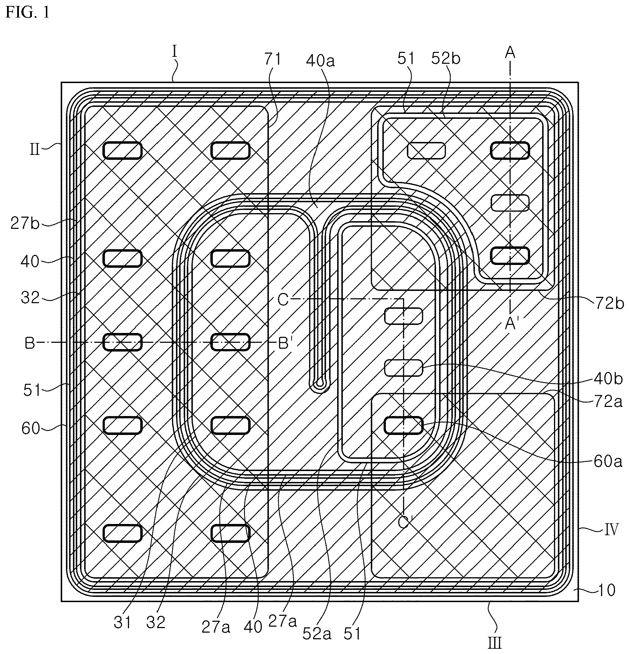

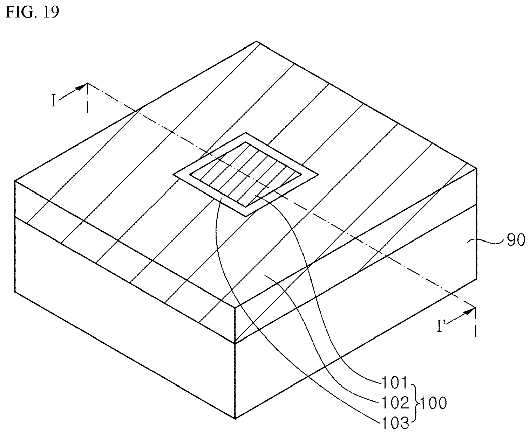

Hereinafter, exemplary embodiments of the present disclosure will be described in detail with reference to the accompanying drawings. FIG. 1 to FIG. 18 show light emitting diodes according to various exemplary embodiments of the present disclosure and FIG. 19 to FIG. 22 show light emitting diode packages according to various exemplary embodiments of the present disclosure.

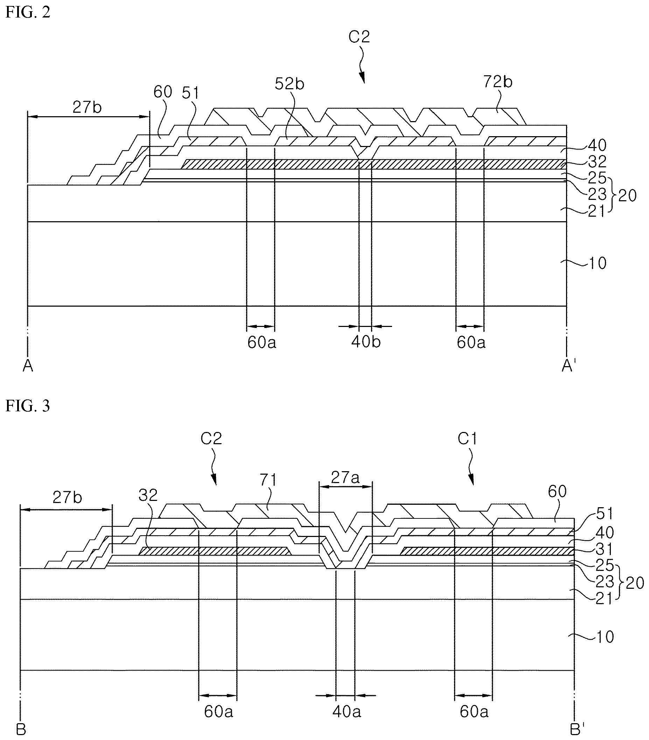

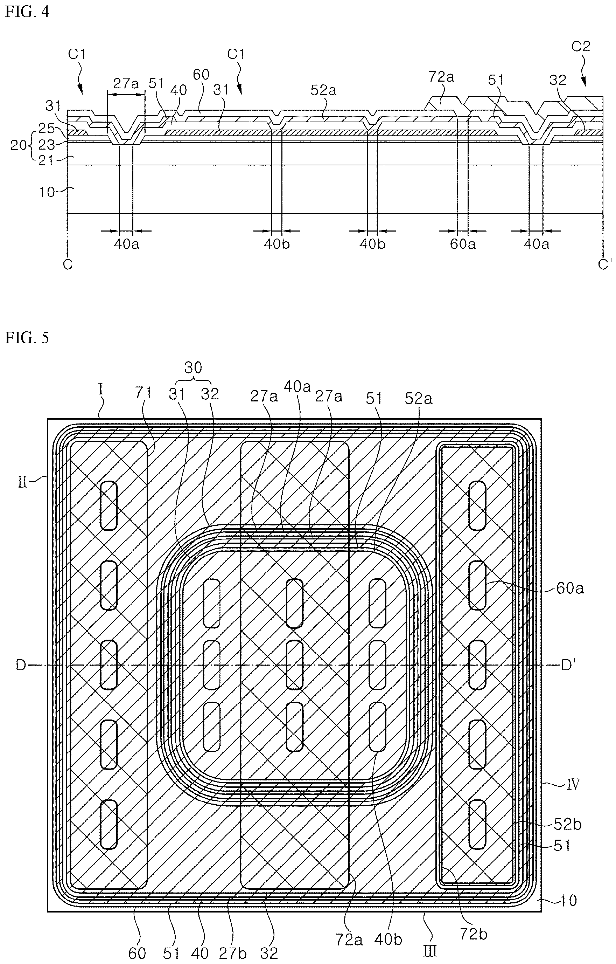

FIG. 1 to FIG. 4 show a light emitting diode according to one exemplary embodiment of the present disclosure. Specifically, FIG. 1 is a top plan view of a light emitting diode according to one exemplary embodiment of the present disclosure, FIG. 2 is a cross-sectional view taken along line A-A' of FIG. 1, FIG. 3 is a cross-sectional view taken along line B-B' of FIG. 1, and FIG. 4 is a cross-sectional view taken along line C-C' of FIG. 1.

The light emitting diode according to this exemplary embodiment may be a chip-scale package type light emitting diode, for which a packaging process is performed at the chip level. Such a light emitting diode has a smaller size than typical packages and does not require a separate packaging process, thereby providing an advantage of process simplification.

Referring to FIG. 2 to FIG. 4, the light emitting diode according to this exemplary embodiment includes a substrate 10, a semiconductor stack 20, ohmic reflective layers 31, 32, a lower insulation layer 40, a first pad metal layer 51, second pad metal layers 52a, 52b, an upper insulation layer 60, a first bump pad 71, and second bump pads 72a, 72b.

The substrate 21 may be selected from any substrates suitable for growth of a gallium nitride-based semiconductor layer. For example, the substrate 21 may include a sapphire substrate, a gallium nitride substrate, a silicon carbide substrate, and the like. In this exemplary embodiment, the substrate 21 may be a patterned sapphire substrate (PSS). As shown in the top plan view of FIG. 1, the substrate 10 may have a rectangular shape or a square shape, without being limited thereto. The size of the substrate 10 is not limited to a particular size and may be selected in various ways. The substrate 10 may include a first side I, a second side II, a third side III, and a fourth side IV. The third side III is opposite the first side I and the fourth side IV is opposite the second side II.

The semiconductor stack 20 includes a first conductivity type semiconductor layer 21, an active layer 23, and a second conductivity type semiconductor layer 25. The first conductivity type semiconductor layer 21 may be disposed on the substrate 10. The first conductivity type semiconductor layer 21 is grown on the substrate 10 and may include a gallium nitride semiconductor layer doped with dopants, for example, Si. The active layer 23 and the second conductivity type semiconductor layer 25 may be disposed on the first conductivity type semiconductor layer 21. The active layer 23 is interposed between the first conductivity type semiconductor layer 21 and the second conductivity type semiconductor layer 25. As described below, the active layer 23 and the second conductivity type semiconductor layer 25 may be formed by etching to have a mesa shape on the first conductivity type semiconductor layer 21. Thus, the active layer 23 and the second conductivity type semiconductor layer 25 have a smaller area than the first conductivity type semiconductor layer 21.

The semiconductor stack 20 includes mesa-etched regions 27a, 27b in which the first conductivity type semiconductor layer 21 is exposed through the second conductivity type semiconductor layer 25 and the active layer 23. Referring to FIG. 1, the mesa-etched regions 27a, 28b may be disposed in an inner region and an outer region of the substrate 10, respectively. Particularly, the mesa-etched region 27a disposed in the inner region of the substrate 10 is referred to as a mesa trench 27a (hereinafter referred to as the 'mesa trench 27a').

In this exemplary embodiment, the first conductivity type semiconductor layer 21 is exposed and an upper surface of the substrate 10 is not exposed in the mesa-etched region 27b. However, it should be understood that other implementations are possible. Alternatively, the upper surface of the substrate 10 may be partially exposed near an edge thereof by an isolation process before or after mesa etching.

The mesa trench 27a includes a closed loop structure having various shapes. Referring to FIG. 1, the mesa trench 27a generally has a rectangular shape with rounded corners. In addition, the mesa trench 27a may have an indented portion formed at the middle of a rectangular shape and extending from one side of the rectangular shape to an opposite side thereof. With this structure, the area of the first conductivity type semiconductor layer exposed to the outside in the mesa trench 27a can be increased. However, it should be understood that the shape of the mesa trench 27a is not limited to the shape shown in FIG. 1 and may be modified into various shapes, as needed.

The semiconductor stack 20 includes a first light emitting region C1 and a second light emitting region C2, which are divided by the mesa trench 27a. According to this exemplary embodiment, each of the first and second light emitting regions C1, C2 includes the first conductivity type semiconductor layer 21, the active layer 23 and the second conductivity type semiconductor layer 25 such that the first conductivity type semiconductor layer 21 of the first light emitting region C1 and the first conductivity type semiconductor layer 21 of the second light emitting region C2 form a continuous structure instead of being disconnected from each other. That is, referring to FIG. 3 and FIG. 4, the mesa trench 27a exposes the first conductivity type semiconductor layer 21 through the second conductivity type semiconductor layer 25 and the active layer 23, such that the first conductivity type semiconductor layer 21 of the first and second light emitting regions C1, C2 has a continuous structure in the mesa trench 27a. Accordingly, the first and second light emitting regions C1, C2 share the first conductivity type semiconductor layer 21.

The shape of the first light emitting region C1 disposed inside the mesa trench 27a may be determined depending upon the shape of the mesa trench 27a. For example, referring to FIG. 1, since the mesa trench 27a has a closed loop shape with rounded corners, the first light emitting region C1 disposed inside the mesa trench 27a may have a rectangular shape with rounded corners. In addition, since the mesa trench 27a has the indented portion extending from one side of a rectangular shape to the opposite side thereof, the first light emitting region C1 may include an indented region extending from one side of a rectangular shape to an opposite side thereof. The indented region is the same as the indented portion of the mesa trench 27a and the first conductivity type semiconductor layer 21 may be exposed in the indented region.

The second light emitting region C2 disposed outside the mesa trench 27a is separated from the first light emitting region C1 by the mesa trench 27a while surrounding the first light emitting region C1. The first and second light emitting regions C1, C2 may have a common center. An inner line of the second light emitting region C2 may be determined by the mesa trench 27a and an outer liner thereof may be determined by the mesa-etched region 27b.

The ohmic reflective layers 31, 32 are disposed on the second conductivity type semiconductor layer 25 of the first light emitting region C1 and the second light emitting region C2, respectively. The ohmic reflective layers 31, 32 may be electrically connected to the second conductivity type semiconductor layer 25. The ohmic reflective layer 31 disposed in the first light emitting region C1 and the ohmic reflective layer 32 disposed in the second light emitting region C2 may be separated from each other by the mesa trench 27a.

The ohmic reflective layers 31, 32 may be disposed substantially over the entire region of the second conductivity type semiconductor layer 25 of the first and second light emitting regions C1, C2. For example, the ohmic reflective layers 31, 32 may cover 80% or more, specifically 90% or more, of the entire region of the second conductivity type semiconductor layer 25 of the first and second light emitting regions C1, C2. Here, in order to prevent damage to the ohmic reflective layers 31, 32 caused by moisture from the mesa trench 27a or an edge of the substrate 10, edges of the ohmic reflective layers 31, 32 may be disposed inside an edge of the second conductivity type semiconductor layer 25 in the first and second light emitting regions C1, C2.

Each of the ohmic reflective layers 31, 32 includes a reflective metal layer and thus can reflect light, which is generated from the active layer 23 and reaches the ohmic reflective layers 31, 32, towards the substrate 10. For example, the ohmic reflective layers 31, 32 may be composed of a single reflective layer, without being limited thereto. Alternatively, each of the ohmic reflective layers 31, 32 may include an ohmic layer and a reflective layer. The ohmic layer may be a metal layer such as a Ni layer or a transparent layer such as an indium tin oxide (ITO) layer, and the reflective layer may be a metal layer having high reflectivity such as an Ag or Al layer.

The lower insulation layer 40 covers the first and second light emitting regions C1, C2 and the ohmic reflective layers 31, 32. The lower insulation layer 40 may cover not only upper surfaces of the first and second light emitting regions C1, C2, but also the mesa trench 27a interposed between the first and second light emitting regions C1, C2 and a side surface of the second light emitting region C2.

Here, the lower insulation layer 40 includes a first opening 40a disposed inside the mesa trench 27a and exposing the first conductivity type semiconductor layer 21. As shown in FIG. 1, the first opening 40a may be composed of a single continuous opening. Alternatively, the first opening 40a may include a plurality of openings separated from each other.

Further, the lower insulation layer 40 covering the side surface of the second light emitting region C2 may cover a portion of the first conductivity type semiconductor layer 21, which is exposed on the side surface of the second light emitting region C2 by mesa etching. Here, the remaining portion of the exposed first conductivity type semiconductor layer 21 is not covered by the lower insulation layer 40 to be connected to the first pad metal layer 51, as described below.

The lower insulation layer 40 may include second openings 40b exposing the ohmic reflective layers 31, 32. The lower insulation layer 40 may include one or more second openings 40b in each of the first and second light emitting regions C1, C2. Referring to FIG. 1, each of the first and second light emitting regions C1, C2 includes two second openings 40b. However, it should be understood that the number, shape and locations of the second openings 40b are not limited to those of the second openings shown in FIG. 1 and may be modified in various ways without departing from the scope of the present disclosure.

The lower insulation layer 40 may be composed of a single layer of SiO₂ or Si₃N₄, without being limited thereto. For example, the lower insulation layer 40 may have a multilayer structure including a silicon nitride layer and a silicon oxide layer, and may include a distributed Bragg reflector in which layers of different refractive indexes, such as SiO₂ layers, TiO₂ layers, ZrO₂ layers, MgF₂ layers, or Nb₂O₅ layers, are alternately stacked one above another. In addition, the lower insulation layer 40 may have a stacked structure, all parts of which have the same structure, without being limited thereto. Alternatively, the lower insulation layer 40 may have a stacked structure, a certain portion of which includes a greater number of layers than other portions thereof. Specifically, the lower insulation layer 40 on the ohmic reflective layer 30 may have a greater thickness than the lower insulation layer 40 around the ohmic reflective layer 30.

The first pad metal layer 51 and the second pad metal layers 52a, 52b are disposed on the lower insulation layer 40.

The first pad metal layer 51 may be disposed in most regions on the lower insulation layer 40 excluding some regions in which the second pad metal layers 52a, 52b are disposed. In addition, the first pad metal layer 51 may cover an edge of the lower insulation layer 40 along the periphery of the second light emitting region C2.

Referring to FIG. 1, FIG. 2 and FIG. 4, the first pad metal layer 51 is connected to the first conductivity type semiconductor layer 21 through the first opening 40a of the lower insulation layer 40. In addition, the first pad metal layer 51 may be connected to the first conductivity type semiconductor layer 21, which is exposed outside the second light emitting region C2 by mesa etching.

According to this exemplary embodiment, the mesa trench 27a is disposed between the first and second light emitting regions C1, C2 to expose the first conductivity type semiconductor layer 21, and the first conductivity type semiconductor layer 21 of the first light emitting region C1 and the first conductivity type semiconductor layer 21 of the second light emitting region C2 form a continuous structure through the first conductivity type semiconductor layer 21 remaining on the mesa trench 27a. That is, the first conductivity type semiconductor layers 21 in the first and second light emitting regions C1, C2 may be electrically connected to each other.

Accordingly, the first pad metal layer 51 connected to the first conductivity type semiconductor layer 21 through the first opening 40a may also be electrically connected to the first conductivity type semiconductor layer 21 of the first and second light emitting regions C1, C2. Further, the first pad metal layer 51 connected to the first conductivity type semiconductor layer 21, which is exposed outside the second light emitting region C2 by mesa etching, may also be electrically connected to the first conductivity type semiconductor layer 21 of the first and second light emitting regions C1, C2.

The second pad metal layers 52a, 52b may be disposed on the lower insulation layer 40 to be separated from the first pad metal layer 51. That is, the second pad metal layers 52a, 52b may be maintained in a state of being electrically disconnected from the first pad metal layer 51. Referring to FIG. 1, the second pad metal layers 52a, 52b may include a second-first pad metal layer 52a in the first light emitting region C1 and a second-second pad metal layer 52b in the second light emitting region C2.

The second-first pad metal layer 52a may be separated from the first pad metal layer 51 in the first light emitting region C1. The second-first pad metal layer 52a may have at least one second opening 40b at a lower side thereof to expose the ohmic reflective layer 31 in the first light emitting region C1. The second-first pad metal layer 52a is connected to the ohmic reflective layer 31 of the first light emitting region C1 exposed through the second opening 40b so as to be electrically connected to the second conductivity type semiconductor layer 25 under the ohmic reflective layer 31. As a result, the second-first pad metal layer 52a may be electrically connected to the second conductivity type semiconductor layer 25 of the first light emitting region C1.

Likewise, the second-second pad metal layer 52b may be separated from the first pad metal layer 51 in the second light emitting region C2 and may have at least one second opening 40b at a lower side thereof to expose the ohmic reflective layer 32 in the second light emitting region C2. The second-second pad metal layer 52b is connected to the ohmic reflective layer 32 of the second light emitting region C2 exposed through the second opening 40b so as to be electrically connected to the second conductivity type semiconductor layer 25 under the ohmic reflective layer 32. As a result, the second-second pad metal layer 52b may be electrically connected to the second conductivity type semiconductor layer 25 of the second light emitting region C2.

The first pad metal layer 51 and the second pad metal layers 52a, 52b may be formed of the same material by the same process after formation of the lower insulation layer 40, and thus may be placed at the same level. Alternatively, the second pad metal layers 52a, 52b may be formed of a different material by a different process from the first pad metal layer 51. On the other hand, each of the first and second pad metal layers 51, 52a, 52b may include a reflective layer, such as an Al layer, which may be formed on a bonding layer such as Ti, Cr or Ni. In addition, a protective layer having a monolayer or multilayer structure, such as Ni, Cr, Au, and the like, may be formed on the reflective layer. Each of the first and second pad metal layers 51, 52a, 52b may have a multilayer structure of, for example, Cr/Al/Ni/Ti/Ni/Ti/Au/Ti.

The upper insulation layer 60 may cover the first and second pad metal layers 51, 52a, 52b. In addition, the upper insulation layer 60 may cover the side surface of the first conductivity type semiconductor layer 21 exposed along the outer periphery of the second light emitting region C2. Further, the upper insulation layer 60 may expose the upper surface of the substrate 10 along the edge of the substrate 10.

The upper insulation layer 60 may include one or more third openings 60a exposing the first pad metal layer 51 and the second pad metal layers 52a, 52b. The third openings 60a may be disposed on each of the first pad metal layer 51, the second-first pad metal layer 52a and the second-second pad metal layer 52b. Referring to FIG. 1, in the first and second light emitting regions C1, C2, ten third openings 60a are disposed on the first pad metal layer 51, and one third opening 60a is disposed on each of the second-first pad metal layer 52a and the second-second pad metal layer 52b. However, it should be understood that the number and shape of the third openings 60a disposed on each of the pad metal layers 51, 52a, 52b are not limited to those shown in FIG. 1 and may be modified in various ways, without departing from the scope of the present disclosure.

On the other hand, as shown in FIG. 1, the third openings 60a of the upper insulation layer 60 may be disposed to be separated from each other in the lateral direction so as not to overlap the second openings 40b of the lower insulation layer 40. That is, the second openings 40b and the third openings 60a may be alternately arranged. With this structure, the light emitting diode can prevent contamination of the ohmic reflective layers 31, 32 by solders by preventing the solders from diffusing into the second openings 40b of the lower insulation layer 40 even when the solders enter the third openings 60a of the upper insulation layer 60. Alternatively, the third openings 60a of the upper insulation layer 60 may be arranged to alternate with the second openings 40b of the lower insulation layer 40.

The upper insulation layer 60 may be composed of a single layer of SiO₂ or Si₃N₄, without being limited thereto. For example, the upper insulation layer 60 may have a multilayer structure including a silicon nitride layer and a silicon oxide layer, and may include a distributed Bragg reflector in which layers of different refractive indexes, such as SiO₂ layers, TiO₂ layers, ZrO₂ layers, MgF₂ layers, or Nb₂O₅ layers, are alternately stacked one above another.

The first bump pad 71 and the second bump pads 72a, 72b may be disposed on the upper insulation layer 60. The first and second bump pads 71, 72a, 72b may have a rectangular shape, without being limited thereto. The shape of the first and second bump pads 71, 72a, 72b may be modified into various shapes.

First, referring to FIG. 1 and FIG. 3, the first bump pad 71 may be disposed on the first light emitting region C1, the mesa trench 27a and the second light emitting region C2. The plural third openings 60a may be disposed under the first bump pad 71 such that the first bump pad 71 is connected to the first pad metal layer 51 through the third openings 60a. Referring to FIG. 1, the first bump pad 71 may be connected to the first pad metal layer 51 through seven third openings 60a in the second light emitting region C2. In addition, the first bump pad 71 may be connected to the first pad metal layer 51 through three third openings 60a in the first light emitting region C1. However, it should be understood that the number and shape of the third openings 60a disposed under the first bump pad 71 are not limited thereto and may be modified in various ways.

In the first and second light emitting regions C1, C2, the first pad metal layer 51 connected to the first bump pad 71 through the third openings 60a may be connected to the first conductivity type semiconductor layer 21 exposed through the first opening 40a of the lower insulation layer 40 in the mesa trench 27a. In addition, the first pad metal layer 51 may be connected to the first conductivity type semiconductor layer 21, which is exposed outside the second light emitting region C2 by mesa etching. With this structure, the first bump pad 71 may be electrically connected to the first conductivity type semiconductor layer 21. As described above, according to this exemplary embodiment, since the first conductivity type semiconductor layer 21 has a continuous structure instead of being disconnected by the mesa trench 27a, the first conductivity type semiconductor layer 21 of the first light emitting region C1 may be electrically connected to the first conductivity type semiconductor layer 21 of the second light emitting region C2 by the first bump pad 71.

The second bump pads 72a, 72b may be connected to the second pad metal layers 52a, 52b through the third openings 60a of the upper insulation layer 60. According to this exemplary embodiment, the second bump pads 72a, 72b may include a second-first bump pad 72a and a second-second bump pad 72b. The second-first bump pad 72a may be disposed near a corner of the substrate 10 at which the third side III of the substrate 10 meets the fourth side IV thereof, and the second-second bump pad 72b may be disposed near a corner of the substrate 10 at which the first side I of the substrate 10 meets the fourth side IV thereof.

Referring to FIG. 1 to FIG. 4, the second-first bump pad 72a may be connected to the second-first pad metal layer 52a through the third openings 60a in the first light emitting region C1, specifically through the third openings 60a disposed on the second-first pad metal layer 52a. As described above, the second-first pad metal layer 52a may be connected to the ohmic reflective layer 31 of the first light emitting region C1 through the second openings 40b of the lower insulation layer 40. With this arrangement, the second-first bump pad 72a may be electrically connected to the second conductivity type semiconductor layer 25 of the first light emitting region C1.

Likewise, the second-second bump pad 72b may be connected to the second-second pad metal layer 52b through the third openings 60a in the second light emitting region C2, specifically through the third openings 60a disposed on the second-second pad metal layer 52b. The second-second pad metal layer 52b may be connected to the ohmic reflective layer 32 of the second light emitting region C2 through the second openings 40b of the lower insulation layer 40. With this arrangement, the second-second bump pad 72b may be electrically connected to the second conductivity type semiconductor layer 25 of the second light emitting region C2.

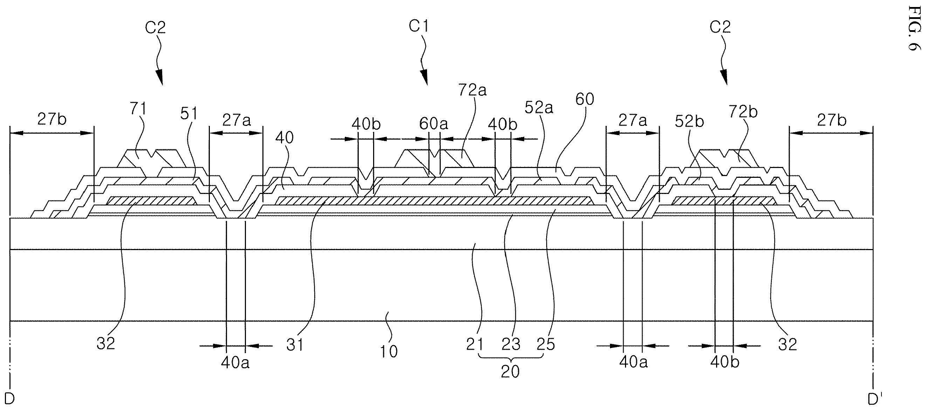

FIG. 5 and FIG. 6 show a light emitting diode according to another exemplary embodiment of the present disclosure. Specifically, FIG. 5 is a top plan view of a light emitting diode according to another exemplary embodiment and FIG. 6 is a cross-sectional view taken along line D-D' of FIG. 5.

The light emitting diode according to this exemplary embodiment is generally similar to the light emitting diode shown in FIG. 1 to FIG. 4 except for the shapes of the mesa trench 27a, the first to third openings 40a, 40b, 60a, the first and second pad metal layers 51, 52a, 52b, and the first and second bump pads 71, 72a, 72b. Hereinafter, detailed description of the same components will be omitted and the following description will focus on different features.

The mesa trench 27a is disposed between the first and second light emitting regions C1, C2. The mesa trench 27a is formed to expose the first conductivity type semiconductor layer 21. The mesa trench 27a may have a closed rectangular loop shape with curved corners. Unlike the mesa trench 27a shown in FIG. 1, the mesa trench 27a according to this exemplary embodiment does not include the indented portion formed at the middle of a rectangular shape and extending from one side of the rectangular shape to the opposite side thereof. Accordingly, the first light emitting region C1 may have a larger area than the second light emitting region C2.

The lower insulation layer 40 includes a first opening 40a exposing the first conductivity type semiconductor layer 21. The first opening 40a is disposed in the mesa trench 27a, whereby the shape of the first opening 40a can be determined depending upon the shape of the mesa trench 27a. Referring to FIG. 5, according to this exemplary embodiment, the first opening 40a may have a rectangular shape with rounded corners, like the mesa trench 27a.

The lower insulation layer 40 may include one or more second openings 40b exposing the ohmic reflective layers 31, 32. The second openings 40b may be disposed on each of the ohmic reflective layers 31, 32 in the first and second light emitting regions C1, C2. Referring to FIG. 5, six second openings 40b are arranged in two rows each including three second openings in the first light emitting region C1 and three second openings 40b are arranged in a line in the second light emitting region C2 near the fourth side IV of the substrate 10. However, it should be understood that the number and shape of the second openings 40b are not limited to those of the second openings shown in FIG. 5 and may be changed in various ways without departing from the scope of the present disclosure.

Referring to FIG. 5 and FIG. 6, the first and second pad metal layers 51, 52a, 52b are disposed on the lower insulation layer 40. The second pad metal layers 52a, 52b may include a second-first pad metal layer 52a and a second-second pad metal layer 52b.

The second-first pad metal layer 52a may be disposed on the lower insulation layer 40 in the first light emitting region C1 inside the mesa trench 27a, and the second-second pad metal layer 52b may be disposed near the fourth side IV of the substrate 10 in the second light emitting region C2 outside the mesa trench 27a. Accordingly, the first pad metal layer 51 is separated from the second-first and second-second pad metal layers 52a, 52b and disposed in the remaining region on the lower insulation layer 40, in which the second-first and second-second pad metal layers 52a, 52b are not disposed.

The first pad metal layer 51 may be connected to the first conductivity type semiconductor layer 21 through the first opening 40a having a closed rectangular loop shape in the mesa trench 27a. In addition, the first pad metal layer 51 may be connected to the first conductivity type semiconductor layer 21, which is exposed outside the second light emitting region C2 by mesa etching. According to this exemplary embodiment, although the first and second light emitting regions C1, C2 are divided from each other by the mesa trench 27a, the first conductivity type semiconductor layer 21 may be continuous in the mesa trench 27a. Accordingly, the first pad metal layer 51 may be commonly connected to the first conductivity type semiconductor layer 21 of the first and second light emitting regions C1, C2.

The second-first pad metal layer 52a may have a rectangular shape, particularly a square shape. The second-first pad metal layer 52a may be connected to the ohmic reflective layer 31 of the first light emitting region C1 through the second openings 40b in the first light emitting region C1. Referring to FIG. 5 and FIG. 6, the second-first pad metal layer 52a may be connected to the ohmic reflective layer 31 of the first light emitting region C1 through seven second openings 40b.

The second-second pad metal layer 52b is disposed near the fourth side IV of the substrate 10 and may have an elongated rectangular bar shape. The second-second pad metal layer 52b may be connected to the ohmic reflective layer 32 of the second light emitting region C2 through the second openings 40b in the second light emitting region C2. Referring to FIG. 5 and FIG. 6, the second-second pad metal layer 52b may be connected to the ohmic reflective layer 32 of the second light emitting region C2 through three second openings 40b arranged in a line.

The upper insulation layer 60 is disposed on the first and second pad metal layers 51, 52a, 52b and may include one or more third openings 60a, which expose the first and second pad metal layers 51, 52a, 52b. Referring to FIG. 5 and FIG. 6, the upper insulation layer 60 may include three third openings 60a arranged in a line in the first light emitting region C1. The third openings 60a disposed in the first light emitting region C1 expose the second-first pad metal layer 52a. Further, the upper insulation layer 60 may include five third openings 60a arranged in a line near the second side □ of the substrate in the second light emitting region C2 and exposing the first pad metal layer 51. Further, the upper insulation layer 60 may include five third openings 60a arranged in a line near the fourth side IV of the substrate and exposing the second-second pad metal layer 52b.

The first bump pad 71 may be disposed near the second side II of the substrate 10 on the upper insulation layer 60. The first bump pad 71 may have an elongated bar shape parallel to the second side II of the substrate 10. The first bump pad 71 may be connected to the first pad metal layer 51 through the third openings 60a of the upper insulation layer 60 in the second light emitting region C2.

Referring to FIG. 5 and FIG. 6, the first bump pad 71 may be connected to the first pad metal layer 51 through five third openings 60a arranged in a line near the second side II of the substrate 10. As described above, the first pad metal layer 51 may be connected to the first conductivity type semiconductor layer 21 exposed on the mesa trench 27a interposed between the first and second light emitting regions C1, C2 or on the side surface of the second light emitting region C2. Thus, the first bump pad 71 may be electrically connected to the first conductivity type semiconductor layer 21. Here, since the first conductivity type semiconductor layer 21 is continuous in the mesa trench 27a, as described above, the first bump pad 71 may be commonly electrically connected to the first conductivity type semiconductor layer 21 of the first and second light emitting regions C1, C2.

The second-first bump pad 72a may be placed at the center of the substrate 10 on the upper insulation layer 60. The second-first bump pad 72a may have an elongated bar shape parallel to the second side II of the substrate 10. The second-first bump pad 72a may be connected to the second-first pad metal layer 52a through the third openings 60a of the upper insulation layer 60 in the first light emitting region C1.

Referring to FIG. 5 and FIG. 6, the second-first bump pad 72a may be connected to the second-first pad metal layer 52a through three third openings 60a arranged in a line in the first light emitting region C1. The second-first pad metal layer 52a may be connected to the ohmic reflective layer 31 of the first light emitting region C1 through the second openings 40b, and the ohmic reflective layer 31 may be connected to the second conductivity type semiconductor layer 25 of the first light emitting region C1. With this connection structure, the second-first bump pad 72a may be electrically connected to the second conductivity type semiconductor layer 25 of the first light emitting region C1.

The second-second bump pad 72b may be disposed near the fourth side IV of the substrate 10 on the upper insulation layer 60. The second-second bump pad 72b may have an elongated bar shape parallel to the second side II of the substrate 10. The second-second bump pad 72b may be connected to the second-second pad metal layer 52b through the third openings 60a of the upper insulation layer 60 in the second light emitting region C2.

Referring to FIG. 5 and FIG. 6, the second-second bump pad 72b may be connected to the second-second pad metal layer 52b through two third openings 60a arranged in a line near the fourth side IV of the substrate 10. The second-second pad metal layer 52b may be connected to the ohmic reflective layer 32 of the second light emitting region C2 through the second openings 40b, and the ohmic reflective layer 32 may be connected to the second conductivity type semiconductor layer 25 of the second light emitting region C2. With this connection structure, the second-second bump pad 72b may be connected to the second conductivity type semiconductor layer 25 of the second light emitting region C2.

Each of the light emitting diodes shown in FIG. 1 to FIG. 6 includes the first and second light emitting regions C1, C2, which can be independently driven. The first conductivity type semiconductor layer 21 of each of the first and second light emitting regions C1, C2 is electrically connected to a single bump pad, that is, the first bump pad 71. Further, the second conductivity type semiconductor layer 25 of the first light emitting region C1 may be electrically connected to the second-first bump pad 72a, and the second conductivity type semiconductor layer 25 of the second light emitting region C2 may be electrically connected to the second-second bump pad 72b.

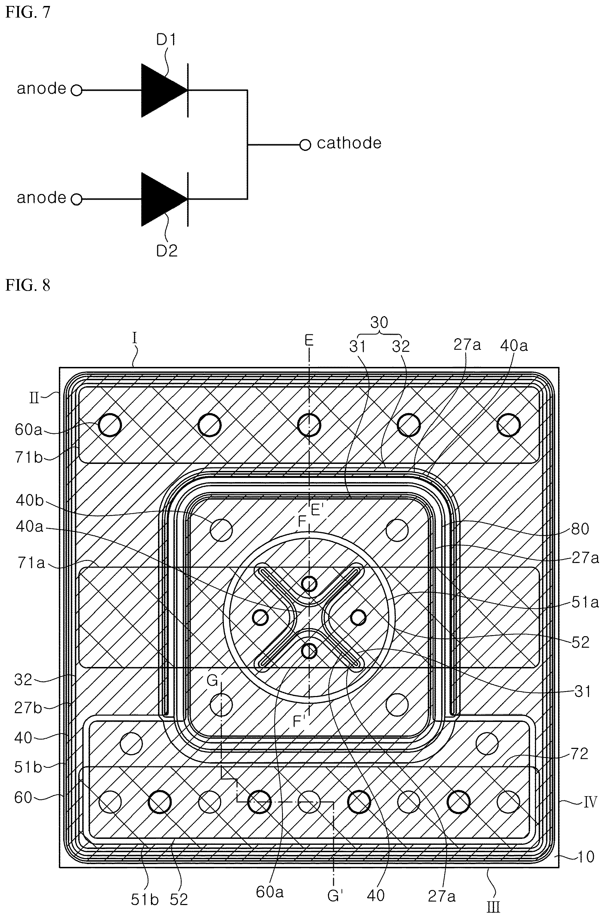

FIG. 7 is a schematic circuit diagram illustrating an electrical connection relationship between the first and second light emitting regions C1, C2 in the light emitting diode shown in FIG. 1 or FIG. 5.

Referring to FIG. 7, a first light emitting diode D1 and a second light emitting diode D2 are shown. Here, the first and second light emitting diodes D1, D2 shown in FIG. 7 correspond to the first and second light emitting regions C1, C2 shown in FIG. 1 or FIG. 5, respectively, for the purpose of illustration. Thus, it should be noted that the first and second light emitting diodes D1, D2 shown in FIG. 7 are not limited to the light emitting diode shown in FIG. 1 or FIG. 5.

Referring to FIG. 7, cathodes of the first and second light emitting diodes D1, D2 are electrically connected to each other. In FIG. 1 or FIG. 5, such an electrical connection structure of the cathodes may correspond to the structure wherein the first bump pad 71 is commonly electrically connected to the first conductivity type semiconductor layer 21 of the first and second light emitting regions C1, C2. Specifically, the electrical connection structure of the cathodes may correspond to the structure wherein the first conductivity type semiconductor layer 21 of the first and second light emitting regions C1, C2 is continuous in the mesa trench 27a and the first bump pad 71 is electrically connected to the first conductivity type semiconductor layer 21 through the first pad metal layer 51.

Further, an anode of the first light emitting diode D1 may correspond to the structure wherein the second-first bump pad 72a is electrically connected to the second conductivity type semiconductor layer 25 of the first light emitting region C1 in FIG. 1 to FIG. 6. Specifically, the anode of the first light emitting diode D1 may correspond to the structure wherein the second-first bump pad 72a is electrically connected to the second conductivity type semiconductor layer 25 of the first light emitting region C1 through the second-first pad metal layer 52a and the ohmic reflective layer 31.

Likewise, an anode of the second light emitting diode D2 corresponds to a structure wherein the second-second bump pad 72b is electrically connected to the second conductivity type semiconductor layer 25 of the second light emitting region C2 in FIG. 1 to FIG. 6. Specifically, the anode of the second light emitting diode D2 corresponds to the structure wherein the second-second bump pad 72b is electrically connected to the second conductivity type semiconductor layer 25 of the second light emitting region C2 through the second-second pad metal layer 52b and the ohmic reflective layer 32.

Referring again to FIG. 1 to FIG. 6, operation of the first light emitting region C1 can be controlled through control of power applied to the first bump pad 71 and the second-first bump pad 72a, and operation of the second light emitting region C2 can be controlled independently of the first light emitting region C1 through control of power applied to the first bump pad 71 and the second-second bump pad 72b. With this structure, operation of the first light emitting region C1 and the second light emitting region C2 can be independently controlled.

With the structure wherein the first light emitting region C1 is placed at the center of the substrate 10 and the second light emitting region C2 is disposed to surround the first light emitting region C1, the light emitting diodes according to the exemplary embodiments enable control of the beam angle of light emitted therefrom. That is, if the ratio of power applied to the first light emitting region C1 is high, the beam angle of light emitted from the light emitting diode can become relatively narrow, and if the ratio of power applied to the second light emitting region C2 is high, the beam angle of light emitted from the light emitting diode can become relatively wide.

For example, if 100% of power is applied to the first light emitting region C1 and no power is applied to the second light emitting region C2, the beam angle of light emitted from the light emitting diode can become a minimum value. Conversely, if 100% of power is applied to the second light emitting region C2 and no power is applied to the first light emitting region C1, the beam angle of light emitted from the light emitting diode can become a maximum value. In addition, the beam angle of light emitted from the light emitting diode can be controlled by applying 50% of power to each of the first and second light emitting regions C1, C2.

With the structure wherein the first light emitting region C1 is placed at the center of the substrate 10 and the second light emitting region C2 is disposed to surround the first light emitting region C1, the light emitting diodes according to the exemplary embodiments enable modularization using a monofocal lens and are advantageous in terms of miniaturization of a light emitting module. However, a typical light emitting diode includes a plurality of light emitting regions, which are generally arranged in the longitudinal direction or in the transverse direction. In such a typical light emitting diode, the plural light emitting regions do not share the same center, thereby making it difficult to achieve modularization using a monofocal lens. That is, such a typical light emitting diode requires a lens having plural foci corresponding to the light emitting regions, thereby making it difficult to achieve modularization.

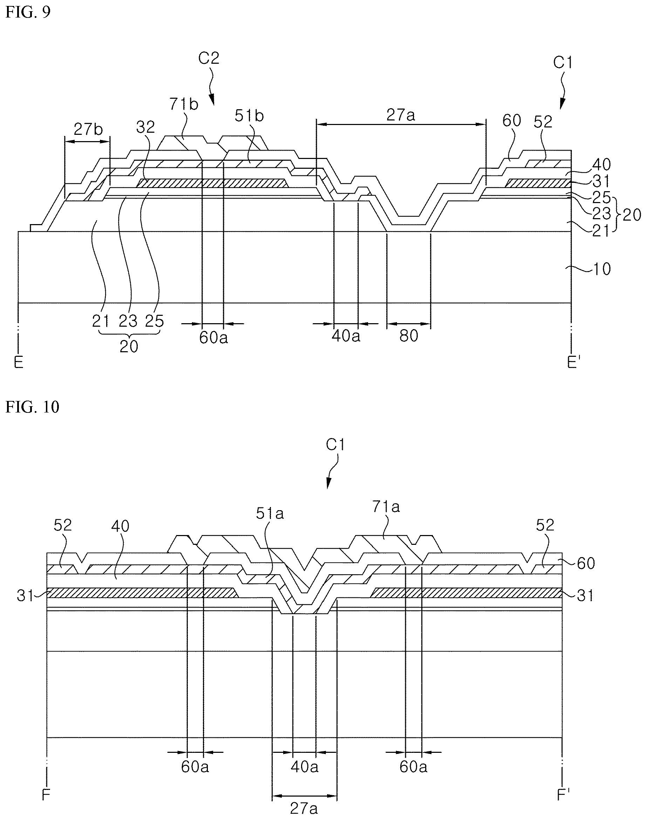

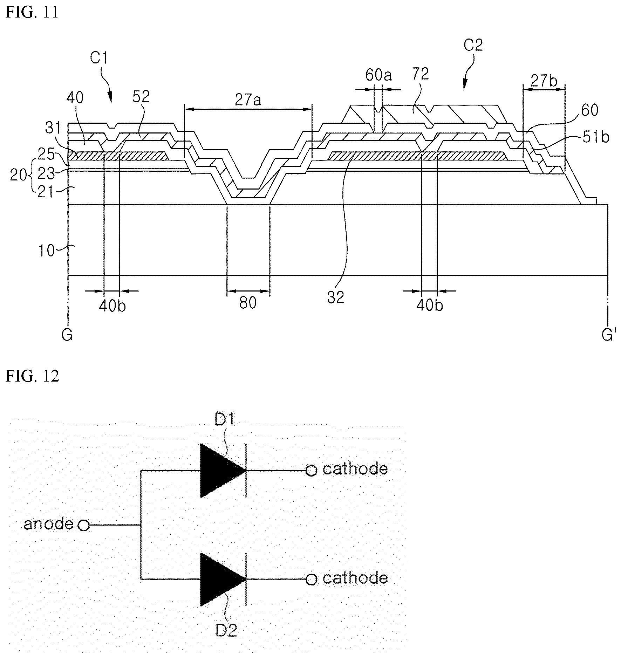

FIG. 8 to FIG. 11 show a light emitting diode according to a further exemplary of the present disclosure. Specifically, FIG. 8 is a top plan view of a light emitting diode according to a further exemplary embodiment, FIG. 9 is a cross-sectional view taken along line E-E' of FIG. 8, FIG. 10 is a cross-sectional view taken along line F-F' of FIG. 8, and FIG. 11 is a cross-sectional view taken along line G-G' of FIG. 8.

The light emitting diode according to this exemplary embodiment is generally similar to the light emitting diode shown in FIG. 1 to FIG. 4 and may further include an isolation trench 80. In addition, the light emitting diode according to this exemplary embodiment is distinguished from the light emitting diode shown in FIG. 1 to FIG. 4 in terms of the shapes of the mesa trench 27a, the first to third openings 40a, 40b, 60a, the first and second pad metal layers 51, 52a, 52b, and the first and second bump pads 71, 72a, 72b. Hereinafter, detailed description of the same components will be omitted and the following description will focus on different features.

Referring to FIG. 8 to FIG. 11, the mesa trench 27a is disposed between the first and second light emitting regions C1, C2 and may also be disposed inside the first light emitting region C1. The mesa trench 27a is formed to expose the first conductivity type semiconductor layer 21 through the second conductivity type semiconductor layer 25 and the active layer 23. Referring to FIG. 8, the mesa trench 27a disposed between the first and second light emitting regions C1, C2 may have a closed rectangular loop shape with rounded corners. Further, the mesa trench 27a disposed inside the first light emitting region C1 may have an 'X' shape therein. The 'X'-shaped mesa trench 27a exposes the first conductivity type semiconductor layer 21 of the first light emitting region C1, and the exposed first conductivity type semiconductor layer 21 may be connected to the first-first pad metal layer 51a, as described below. Here, it should be understood that the shape of the mesa trench 27a is not limited to the mesa trench of FIG. 8 and may be modified into various shapes without departing from the present disclosure.

The isolation trench 80 may be disposed between the first and second light emitting regions C1, C2. The isolation trench 80 may be formed by an isolation process, by which the substrate 10 is exposed through the second conductivity type semiconductor layer 25, the active layer 23 and the first conductivity type semiconductor layer 21. Referring to FIG. 8, FIG. 9 and FIG. 11, the isolation trench 80 may be placed inside the mesa trench 27a interposed between the first and second light emitting regions C1, C2. In examples not forming part of the invention, only the isolation trench 80 may be interposed between the first and second light emitting regions C1, C2 without the mesa trench 27a.

Referring to FIG. 8, FIG. 9 and FIG. 11, according to this exemplary embodiment, the upper surface of the substrate 10 may be partially exposed near an edge thereof, unlike the light emitting diode shown in FIG. 1 or FIG. 5. The upper surface of the substrate 10 near the edge thereof may be exposed by an isolation process before or after mesa etching. Exposing the upper surface of the substrate 10 and forming the isolation trench 80 may be performed by the same process. In other exemplary embodiments, the upper surface of the substrate 10 may not be exposed.

The first and second light emitting regions C1, C2 may be isolated from each other by the isolation trench 80. Since the second conductivity type semiconductor layer 25, the active layer 23 and the first conductivity type semiconductor layer 21 are removed by etching to expose the substrate 10 in the isolation trench 80, the first conductivity type semiconductor layer 21 of the first light emitting region C1 may be separated from the first conductivity type semiconductor layer 21 of the second light emitting region C2 in the isolation trench 80, unlike the mesa trench 27a. That is, in the light emitting diode shown in FIG. 1 to FIG. 4, the first conductivity type semiconductor layer 21 of the first light emitting region C1 is continuously connected to the first conductivity type semiconductor layer 21 of the second light emitting region C2 in the mesa trench 27a, whereas, in light emitting diode according to this exemplary embodiment, the first conductivity type semiconductor layer 21 of the first light emitting region C1 is separated from the first conductivity type semiconductor layer 21 of the second light emitting region C2 in the isolation trench 80.

The lower insulation layer 40 includes a first opening 40a, which exposes the first conductivity type semiconductor layer 21. Referring to FIG. 8 and FIG. 9, the first opening 40a is disposed in the mesa trench 27a interposed between the first and second light emitting regions C1, C2. The first opening 40a shown in FIG. 1 to FIG. 4 has a closed rectangular loop shape with rounded corners like the mesa trench 27a. On the contrary, referring to FIG. 8, the first opening 40a according to this exemplary embodiment has an open loop shape open at one side thereof. That is, in the mesa trench 27a near the third side III of the substrate 10, the first opening 40a exposing the first conductivity type semiconductor layer 21 may not be formed. Referring to FIG. 11, if the opening is formed in the mesa trench 27a near the third side III of the substrate 10 to expose the first conductivity type semiconductor layer 21, a second pad metal layer 52 can be connected to the first conductivity type semiconductor layer 21. To prevent this problem, the first opening is not formed in the mesa trench 27a near the third side III of the substrate 10. In examples not forming part of the invention, wherein the mesa trench 27a is not formed between the first and second light emitting regions C1, C2, the first opening 40a may also be omitted.

In addition, the first opening 40a may be placed inside the 'X'-shaped mesa trench 27a in the first light emitting region C1. Like the mesa trench 27a, the first opening 40a may include an 'X' shape and expose the first conductivity type semiconductor layer 21 of the first light emitting region C1.

First pad metal layers 51a, 51b and a second pad metal layer 52 may be placed on the lower insulation layer 40. The first pad metal layers 51a, 51b may include a first-first pad metal layer 51a and a first-second pad metal layer 51b.

Referring to FIG. 8 and FIG. 10, the first-first pad metal layer 51a may be disposed in the first light emitting region C1 and may include a circular shape. However, it should be understood that the shape of the first-first pad metal layer 51a is not limited thereto and may be modified into various shapes. The 'X'-shaped first opening 40a described above may be disposed under the first-first pad metal layer 51a. The first-first pad metal layer 51a may be connected to the first conductivity type semiconductor layer 21 of the first light emitting region C1 through the 'X'-shaped first opening 40a.

The first-second pad metal layer 51b may be disposed near the first side I of the substrate 10 and may include a shape extending towards the third side III of the substrate 10 along the second and fourth sides II, IV of the substrate such that opposite sides of the shape are disposed inside the mesa trench 27a or the isolation trench 80 (for the structure wherein the mesa trench 27a is omitted). Referring to FIG. 8 and FIG. 9, the first-second pad metal layer 51b may be connected to the first conductivity type semiconductor layer 21 of the first light emitting region C1 through the first opening 40a interposed between the first and second light emitting regions C1, C2. Further, the first-second pad metal layer 51b may be connected to the first conductivity type semiconductor layer 21 of the second light emitting region C2, which is exposed on the side surface of the second light emitting region C2 by mesa etching. Here, the mesa trench 27a may be omitted between first and second light emitting regions C1, C2. In this case, the first-second pad metal layer 51b may be connected only to the first conductivity type semiconductor layer 21 exposed on the side surface of the second light emitting region C2.

The second pad metal layer 52 may be placed in the remaining region on the lower insulation layer 40, in which the first pad metal layers 51a, 51b are not placed. The second pad metal layer 52 may be placed at a lower side of the second light emitting region C2, that is, near the third side III of the substrate 10, and may also be placed in the remaining region of the first light emitting region C1, in which the first-first pad metal layer 51a is not formed. Referring to FIG. 11, the second pad metal layer 52 may be placed inside the mesa trench 27a and the isolation trench 80. As described above, since the first opening 40a is not placed in the mesa trench 27a and the isolation trench 80 near the third side III of the substrate, the lower insulation layer 40 is continuous in the mesa trench 27a and the isolation trench 80 and the second pad metal layer 52 can be prevented from being connected to the first conductivity type semiconductor layer 21 and the active layer 23.

Second openings 40b may be placed under the second pad metal layer 52 to expose the ohmic reflective layers 31, 32. Referring to FIG. 8, seven second openings 40b may be placed under the second pad metal layer 52 in the second light emitting region C2 and four second openings 40b may be placed under the second pad metal layer 52 in the first light emitting region C1. However, it should be understood that the number of second openings 40b is not limited thereto and may be changed in various ways without departing from the scope of the present disclosure.

The second pad metal layer 52 may be connected to the ohmic reflective layer 31 of the first light emitting region C1 and the ohmic reflective layer 32 of the second light emitting region C2 through the second openings 40b. That is, the second pad metal layer 52 can be electrically connected to both the ohmic reflective layers 31, 32 of the first and second light emitting regions C1, C2 by a single second pad metal layer 52. Although the second openings 40b are shown as having a circular shape in FIG. 8, it should be understood that the shape of the second openings is not limited thereto and may be modified into various shapes. Further, the number of second openings 40b may be changed in various ways without departing from the spirit of the present disclosure.

The upper insulation layer 60 is disposed on the first and second pad metal layers 51a, 51b, 52 and may include one or more third openings 60a, which expose the first and second pad metal layers 51a, 51b, 52. Referring to FIG. 8 and FIG. 10, in the first light emitting region C1, the upper insulation layer 60 may include four third openings 60a having a circular shape and disposed between the first openings 40a arranged in an 'X' shape. Due to spatial restriction, these four third openings 60a may have a smaller size than the third openings 60a placed in other regions. Referring to FIG. 8 and FIG. 9, in the second light emitting region C2, the upper insulation layer 60 may include five third openings 60a arranged in a line near the first side I of the substrate 10. Further, in the second light emitting region C2, the upper insulation layer 60 may include four third openings 60a arranged in a line near the third side III of the substrate 10. In this exemplary embodiment, the third openings 60a of the upper insulation layer 60 may be arranged in the longitudinal direction so as not to overlap the second openings 40b of the lower insulation layer 40.

A first-first bump pad 71a may be placed at the center of the substrate 10. Referring to FIG. 8, the first-first bump pad 71a may have an elongated bar shape parallel to the first side I or the third side III of the substrate 10 and may be placed at the middle of the second and fourth sides II, IV.

The first-first bump pad 71a may be connected to the first-first pad metal layer 51a through the third openings 60a. Referring to FIG. 8 and FIG. 10, the first-first bump pad 71a may be connected to the first-first pad metal layer 51a through the third openings 60a of the first light emitting region C1. Here, the first-first pad metal layer 51a may be connected to the first conductivity type semiconductor layer 21 through the X-shaped first opening 40a in the mesa trench 27a. With this structure, the first-first bump pad 71a may be electrically connected to the first conductivity type semiconductor layer 21 in the first light emitting region C1.

A first-second bump pad 71b may be placed near the first side I of the substrate 10. Like the first-first bump pad 71a, the first-second bump pad 71b may have an elongated bar shape parallel to the first side I of the substrate. Referring to FIG. 8 and FIG. 9, the first-second bump pad 71b may be connected to the first-second pad metal layer 51b through the third openings 60a of the second light emitting region C2. Here, the first-second pad metal layer 51b may be connected to the first conductivity type semiconductor layer 21 of the second light emitting region C2 exposed through the first opening 40a disposed in the mesa trench 27a between the first and second light emitting regions C1, C2. Further, the first-second pad metal layer 51b may be connected to the first conductivity type semiconductor layer 21 of the second light emitting region C2, which is exposed outside the second light emitting region C2 by mesa etching. In a structure wherein only the isolation trench 80 is disposed between the first and second light emitting regions C1, C2 without the mesa trench 27a, the first-second pad metal layer 51b may be connected only to the first conductivity type semiconductor layer 21 exposed outside the second light emitting region C2. With this structure, the first-second bump pad 71b may be electrically connected to the first conductivity type semiconductor layer 21 of the second light emitting region C2.

A second bump pad 72 may be disposed near the third side III of the substrate 10. Like the first bump pads 71a, 71b, the second bump pad 72 may have an elongated bar shape parallel to the first side I of the substrate 10. Referring to FIG. 8 and FIG. 11, in the second light emitting region C2, the second bump pad 72 may be connected to the second pad metal layer 52 through the third openings 60a disposed on the second pad metal layer 52. The second pad metal layer 52 may be connected to the ohmic reflective layers 31, 32 of the first and second light emitting regions C1, C2 through one or more second openings 40b under the second pad metal layer 52.

Specifically, the second pad metal layer 52 may be connected to the ohmic reflective layer 32 of the second light emitting region C2 through the second openings 40b in the second light emitting region C2, and may be connected to the ohmic reflective layer 31 of the first light emitting region C1 through the second openings 40b in the first light emitting region C1. Since the ohmic reflective layers 31, 32 are connected to the second conductivity type semiconductor layer 25 of the first and second light emitting regions C1, C2, the single second pad metal layer 52 may be commonly connected to the second conductivity type semiconductor layer 25 of the first and second light emitting regions C1, C2. As a result, the single second bump pad 72 may be commonly electrically connected to the second conductivity type semiconductor layer 25 of the first and second light emitting regions C1, C2.

The light emitting diode according to this exemplary embodiment includes the first and second light emitting regions C1, C2. Here, the second conductivity type semiconductor layer 25 of the first and second light emitting regions C1, C2 may be electrically connected to one bump pad, that is, the second bump pad 72. Further, the first conductivity type semiconductor layer 21 of the first light emitting region C1 may be electrically connected to the first-first bump pad 71a and the first conductivity type semiconductor layer 21 of the second light emitting region C2 may be electrically connected to the first-second bump pad 71b.

FIG. 12 is a schematic circuit diagram illustrating an electrical connection relationship between the first and second light emitting regions C1, C2 in the light emitting diode shown in FIG. 8.

Referring to FIG. 12, a first light emitting diode D1 and a second light emitting diode D2 are shown. Here, the first and second light emitting diodes D1, D2 shown in FIG. 12 correspond to the first and second light emitting regions C1, C2 shown in FIG. 8, respectively, for the purpose of illustration. Thus, it should be noted that the first and second light emitting diodes D1, D2 shown in FIG. 12 are not limited to the light emitting diode shown in FIG. 8.

Referring to FIG. 12, anodes of the first and second light emitting diodes D1, D2 are electrically connected to each other. In FIG. 8, such an electrical connection structure of the anodes may correspond to the structure wherein the second bump pad 72 is commonly electrically connected to the second conductivity type semiconductor layer 23 of the first and second light emitting regions C1, C2. Specifically, the electrical connection structure of the anodes may correspond to the structure wherein the second bump pad 72 is connected to the second pad metal layer 52 and the second pad metal layer 52 is commonly connected to the ohmic reflective layers 31, 32 of the first and second light emitting regions C1, C2, whereby the second bump pad 72 is electrically connected to the second conductivity type semiconductor layer 25 of the first and second light emitting regions C1, C2.

Further, a cathode of the first light emitting diode D1 may correspond to the structure wherein the first-first bump pad 71a is electrically connected to the first conductivity type semiconductor layer 21 of the first light emitting region C1 in FIG. 8 to FIG. 11. Specifically, the cathode of the first light emitting diode D1 may correspond to the structure wherein the first-first bump pad 71a is electrically connected to the first conductivity type semiconductor layer 21 of the first light emitting region C1 through the first-first pad metal layer 51a. Likewise, a cathode of the second light emitting diode D2 may correspond to the structure wherein the first-second bump pad 71b is electrically connected to the first conductivity type semiconductor layer 21 of the second light emitting region C2 in FIG. 8 to FIG. 11. Specifically, the cathode of the second light emitting diode D2 may corresponds to the structure wherein the first-second bump pad 71b is electrically connected to the first conductivity type semiconductor layer 21 of the second light emitting region C2 through the first-second pad metal layer 51b.

Referring again to FIG. 8 to FIG. 11, operation of the first light emitting region C1 can be controlled through control of power applied to the first-first bump pad 71a and the second bump pad 72. In addition, operation of the second light emitting region C2 can be controlled independently of the first light emitting region C1 through control of power applied to the first-second bump pad 71b and the second bump pad 72. That is, the first light emitting region C1 and the second light emitting region C2 can be independently driven.

Like the light emitting diodes shown in FIG. 1 to FIG. 6, with the structure wherein the first light emitting region C1 is placed at the center of the substrate 10 and the second light emitting region C2 surrounds the first light emitting region C1, the light emitting diode according to this exemplary embodiment enables control of the beam angle of light emitted therefrom.

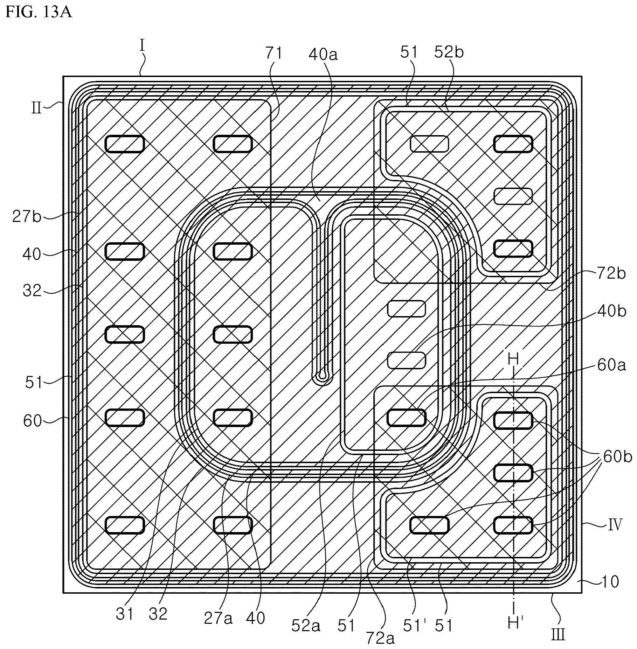

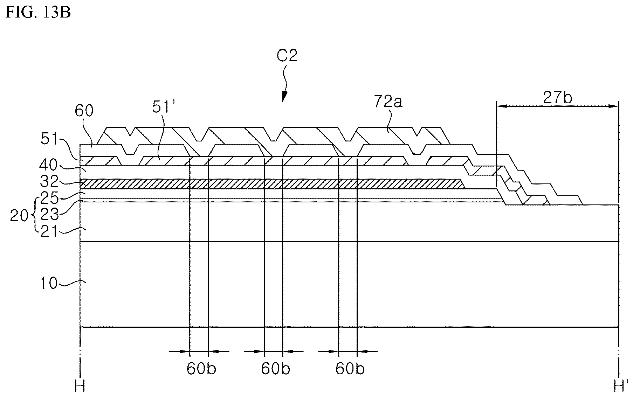

FIG. 13 to FIG. 15 show light emitting diodes according to other exemplary embodiments of the present disclosure. Each of the light emitting diodes according to these exemplary embodiments includes an opening for heat dissipation in the upper insulation layer 60 under the bump pads 71, 72a, 72b in order to enhance reliability through improvement in heat dissipation efficiency. Specifically, the light emitting diodes shown in FIG. 13, FIG. 14 and FIG. 15 further include heat dissipation structures in addition to the components of the light emitting diodes shown in FIG. 1, FIG. 5 and FIG. 8, respectively.

FIG. 13A is a top plan view of a light emitting diode according to another exemplary embodiment of the present disclosure and FIG. 13B is a cross-sectional view taken along line H-H' of FIG. 13A. The light emitting diode shown in FIG. 13 is substantially the same as the light emitting diode shown in FIG. 1 except that the first pad metal layer 51 includes an isolation region 51' and fourth openings 60b of the upper insulation layer 60 are placed on the isolation region 51' of the first pad metal layer 51. The following description will focus on the different features of this exemplary embodiment.

The first pad metal layer 51 may include the isolation region 51' near a corner at which the third side III of the substrate 10 meets the fourth side IV thereof. The isolation region 51' may be disposed under the second-first bump pad 72a. Referring to FIG. 13A and FIG. 13B, the isolation region 51' is separated from the other region of the first pad metal layer 51 and may be separated from the ohmic reflective layer 32 of the second light emitting region C2 by the lower insulation layer 40.

The upper insulation layer 60 may include fourth openings 60b disposed in the isolation region 51' to expose the isolation region 51'. The fourth openings 60b have the same shape as the third openings 60a and are placed at different locations than the third openings 60a. Referring to FIG. 13, four fourth openings 60b are interposed between the isolation region 51' and the second-first bump pad 72a. The second-first bump pad 72a may be connected to the isolation region 51' through the fourth openings 60b. Here, since electrical connection between the isolation region 51' and other portions is blocked, the second-first bump pad 72a cannot be electrically connected to the semiconductor stack 20 through the isolation region 51'. That is, as described above in FIG. 1 to FIG. 4, the second-first bump pad 72a is electrically connected to the first conductivity type semiconductor layer 21 of the first light emitting region C1 without being electrically connected to other portions by the isolation region 51'.

Upon operation of the light emitting diode, heat generated from the semiconductor stack 20, particularly from the active layer 23, can be efficiently dissipated through the fourth openings 60b. Specifically, referring to FIG. 13B, heat generated from the active layer 23 can be transferred to the isolation region 51' through the ohmic reflective layer 32 and the lower insulation layer 40. The heat transferred to the isolation region 51' can be discharged from the light emitting diode through the second-first bump pad 72a connected to the isolation region 51' through the fourth openings 60b and having a relatively large volume.

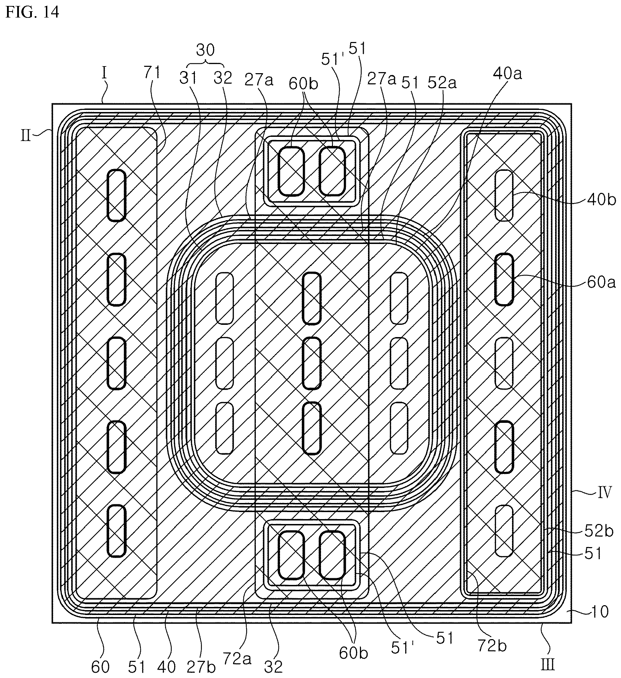

FIG. 14 is a top plan view of a light emitting diode according to another exemplary embodiment of the present disclosure. The light emitting diode shown in FIG. 14 is substantially the same as the light emitting diode shown in FIG. 5 except that the first pad metal layer 51 includes isolation regions 51' and the upper insulation layer 60 includes fourth openings 60b disposed on the isolation regions 51'.

Referring to FIG. 14, the first pad metal layer 51 may include isolation regions 51' at the middle of the substrate 10 near the first side I and the third side III of the substrate 10. Each of the isolation regions 51' may be disposed under the second-first bump pad 72a.

The upper insulation layer 60 may include fourth openings 60b disposed in each of the isolation regions 51' and exposing the isolation region 51'. Referring to FIG. 14, a pair of fourth openings 60b may be disposed in each of the isolation regions 51'. The second-first bump pad 72a may be connected to the isolation regions 51' through the fourth openings 60b. With this structure, heat generated from the semiconductor stack 20 can be efficiently discharged from the light emitting diode through the second-first bump pad 72a by the same mechanism as that of the light emitting diode shown in FIG. 13.

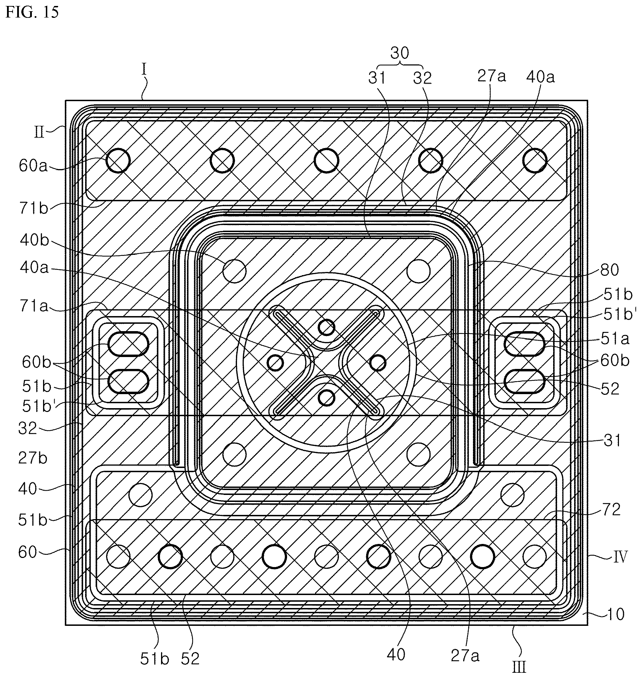

FIG. 15 is a top plan view of a light emitting diode according to another exemplary embodiment of the present disclosure. The light emitting diode shown in FIG. 15 is substantially the same as the light emitting diode shown in FIG. 8 except that the first-second pad metal layer 51b includes isolation regions 51b' and the upper insulation layer 60 includes fourth openings 60b disposed on the isolation regions 51b'.

Referring to FIG. 15, the first-second pad metal layer 51b may include isolation regions 51b' at the middle of the substrate 10 near the second side II and the fourth side IV of the substrate 10. Each of the isolation regions 51b' may be disposed under the first-first bump pad 71a.

The upper insulation layer 60 may include fourth openings 60b disposed in each of the isolation regions 51' and exposing the isolation region 51'. Referring to FIG. 15, a pair of fourth openings 60b may be disposed in each of the isolation regions 51'. The first-first bump pad 71a may be connected to the isolation regions 51' through the fourth openings 60b. With this structure, heat generated from the semiconductor stack 20 can be efficiently discharged from the light emitting diode through the first-first bump pad 71a by the same mechanism as that of the light emitting diode shown in FIG. 13.

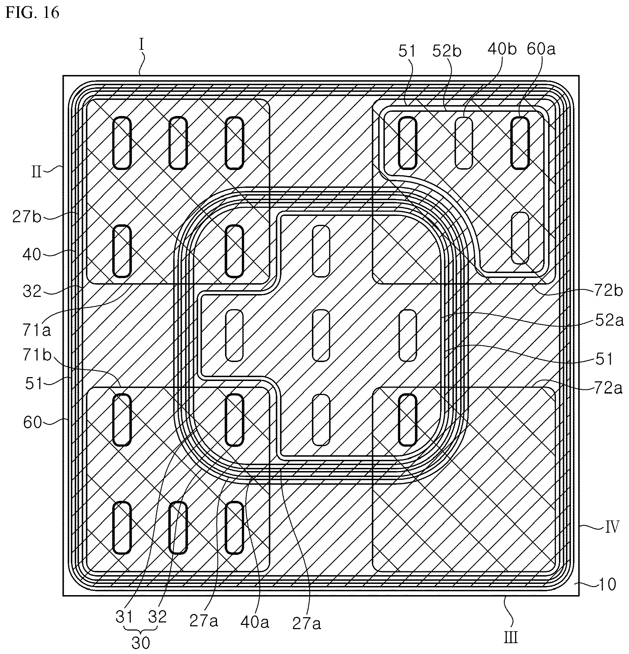

FIG. 16 is a top plan view of a light emitting diode according to yet another exemplary embodiment of the present disclosure. The light emitting diode shown in FIG. 16 is substantially the same as the light emitting diode shown in FIG. 1 excluding the number and arrangement of the mesa trench 27a, the first and second pad metal layers 51, 52a, 52b, the first to third openings 40a, 40b, 60a, and the shapes of the first bump pads 71a, 71b. However, the structure of the light emitting diode including a semiconductor stack 20, ohmic reflective layers 31, 32, a lower insulation layer 40, first and second pad metal layers 51, 52a, 52b, and an upper insulation layer 60 is the same as the structure of the light emitting diode shown in FIG. 1. Thus, a cross-sectional shape corresponding to FIG. 16 is omitted.

The mesa trench 27a is disposed between the first and second light emitting regions C1, C2 and may have a closed rectangular loop structure with curved corners. According to this exemplary embodiment, the mesa trench 27a does not include the indented portion formed at the middle of the rectangular shape and extending from one side of the rectangular shape to the opposite side thereof, unlike the mesa trench 27a shown in FIG. 1. Accordingly, the first light emitting region C1 of the light emitting diode according to this exemplary embodiment may have a larger area than that of the light emitting diode shown in FIG. 1.

The lower insulation layer 40 includes a first opening 40a disposed in the mesa trench 27a and exposing the first conductivity type semiconductor layer 21. The first opening 40a may have a closed rectangular loop shape with rounded corners, like the mesa trench 27a. The lower insulation layer 40 includes second openings 40b disposed on the ohmic reflective layers 31, 32 of the first and second light emitting regions C2, C2 and partially exposing the ohmic reflective layers 31, 32. Referring to FIG. 16, five second openings 40b may be placed in the first light emitting region C1 and two second openings 40b may be placed in the second light emitting region C2. It should be understood that the number and shape of the second openings 40b are not limited to those of the second openings shown in FIG. 16 and may be changed in various ways without departing from the scope of the present disclosure.

The first pad metal layer 51 may cover the second light emitting region C2 and the lower insulation layer 40. Here, the first pad metal layer 51 may not be formed near a corner of the substrate at which the first side I of the substrate 10 meets the fourth side IV thereof. In addition, the first pad metal layer 51 may cover the mesa trench 27a and a portion of the first light emitting region C1. Referring to FIG. 16, the first pad metal layer 51 may cover a portion of left upper and lower ends of the first light emitting region C1. The first pad metal layer 51 may be connected to the first conductivity type semiconductor layer 21 through the first opening 40a. However, it should be understood that the shape of the first pad metal layer 51 is not limited thereto and may be modified into various shapes so long as the first pad metal layer 51 can be connected to the first conductivity type semiconductor layer 21 through the first opening 40a.

The second-first pad metal layer 52a may cover the first light emitting region C1 and the lower insulation layer 40. The second-first pad metal layer 52a may have a rectangular shape with rounded corners, in which left upper and lower ends of the rectangular shape are partially depressed. The second-first pad metal layer 52a may be separated from the first pad metal layer 51. The second-first pad metal layer 52a may be connected to the ohmic reflective layer 31 of the first light emitting region C1 through the second openings 40b.

The second-second pad metal layer 52b may cover the lower insulation layer 40 of the second light emitting region C2. The second-second pad metal layer 52b may have the same shape as the second-second pad metal layer 52b shown in FIG. 1.

The first bump pads 71a, 71b may include a first-first bump pad 71a and a first-second bump pad 71b. The first-first bump pad 71a and the first-second bump pad 71b may have a rectangular shape. The first-first bump pad 71a may be disposed near a corner of the substrate 10 at which the first side I of the substrate 10 meets the second side II thereof, and the first-second bump pad 71b may be disposed near a corner of the substrate 10 at which the second side II of the substrate 10 meets the third side III thereof. Each of the first-first bump pad 71a and the first-second bump pad 71b may be connected to the first pad metal layer 51 through the third openings 60a of the upper insulation layer 60.

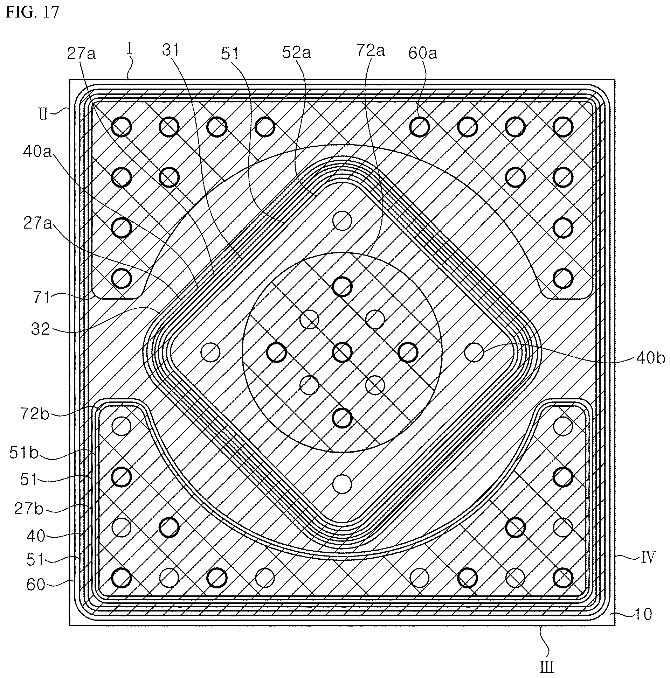

FIG. 17 is a top plan view of a light emitting diode according to yet another exemplary embodiment of the present disclosure. The light emitting diode shown in FIG. 17 is substantially the same as the light emitting diode shown in FIG. 5 excluding the shapes of the mesa trench 27a, the first and second light emitting regions C1, C2, the first to third openings 40a, 40b, 60a, the first and second pad metal layers 51, 52a, 52b, and the first and second bump pads 71, 72a, 72b. Hereinafter, detailed description of the same components will be omitted and the following description will focus on different features.

The mesa trench 27a is disposed between the first and second light emitting regions C1, C2 and may have a closed loop structure of a rhombus shape with respect to the substrate 10. The first conductivity type semiconductor layer 21 is exposed in the mesa trench 27a. The shapes of the first and second light emitting regions C1, C2 may be determined depending upon the shape of the mesa trench 27a. That is, the first light emitting region C1 disposed in the mesa trench 27a may have a rhombus shape, like the mesa trench 27a. Further, the second light emitting region C2 disposed outside the mesa trench 27a may have a shape surrounding the first light emitting region C1 with reference to the mesa trench 27a. As described above in the exemplary embodiment shown in FIG. 5, the first conductivity type semiconductor layer 21 of the first light emitting region C1 may be continuously connected to the first conductivity type semiconductor layer 21 of the second light emitting region C2 in the mesa trench 27a.

The lower insulation layer 40 includes a first opening 40a, which exposes the first conductivity type semiconductor layer 21. The first opening 40a is disposed inside the mesa trench 27a. Thus, the first opening 40a may also have a rhombus shape, like the mesa trench 27a.

The lower insulation layer 40 may include second openings 40b, which expose the ohmic reflective layers 31, 32. The second openings 40b may have a circular shape. The second openings 40b may be disposed in each of the first and second light emitting regions C1, C2. Referring to FIG. 17, a plurality of second openings 40b may be disposed in the first light emitting region C1, and a plurality of second openings 40b may also be disposed near the fourth side IV of the substrate 10 in the second light emitting region C2. The plural second openings 40b may be arranged at constant intervals in each of the first and second light emitting regions C1, C2 in order to achieve efficient current spreading.

The first pad metal layer 51 is disposed on the lower insulation layer 40. The first pad metal layer 51 may have a shape substantially surrounding the first light emitting region C1. Referring to FIG. 17, the first pad metal layer 51 extends to an inner portion of the mesa trench 27a to cover a periphery of the first light emitting region C1. Further, the first pad metal layer 51 may not be disposed near the third side III of the substrate 10 in order to allow formation of the second pad metal layer 52. The first pad metal layer 51 is connected to the first conductivity type semiconductor layer 21 exposed through the first opening 40a in the mesa trench 27a. Further, the first pad metal layer 51 is connected to the first conductivity type semiconductor layer 21, which is exposed on the side surface of the second light emitting region C2 by mesa etching. In this structure, the first pad metal layer 51 may be commonly connected to the first conductivity type semiconductor layer 21 of the first and second light emitting regions C1, C2.

The second pad metal layers 52a, 52b may include a second-first pad metal layer 52a disposed in the first light emitting region C1 and a second-second pad metal layer 52b disposed in the second light emitting region C2. The second-first and second-second pad metal layers 52a, 52b may be separated from the first pad metal layer 51.

The second-first pad metal layer 52a may be disposed in the first light emitting region C1 and surrounded by the first pad metal layer 51. Like the mesa trench 27a, the second-first pad metal layer 52a may have a rhombus shape. The second-second pad metal layer 52b may be disposed along the third side III of the substrate 10 in the second light emitting region C2 and has both sides extending towards the first side I of the substrate 10 along the second and fourth sides II, IV of the substrate 10. Referring to FIG. 17, the second-first pad metal layer 52a may be connected to the ohmic reflective layer 31 of the first light emitting region C1 through four second openings 40b and the second-second pad metal layer 52b may be connected to the ohmic reflective layer 32 of the second light emitting region C2 through eight second openings 40b.

The upper insulation layer 60 may cover the first and second pad metal layers 51, 52a, 52b and include third openings 60a. The third openings 60a may have a circular shape. The third openings 60a may be disposed in the first and second light emitting regions C1, C2 and expose the first and second pad metal layers 51, 52a, 52b.

The first bump pad 71 may be disposed along the first side I of the substrate 10 in the second light emitting region C2 and has both sides extending towards the third side III of the substrate 10 along the second and fourth sides II, IV of the substrate 10. A plurality of third openings 60a may be disposed under the first bump pad 71 such that the first bump pad 71 can be connected to the first pad metal layer 51 through the third openings 60a. Since the first pad metal layer 51 is connected to the first conductivity type semiconductor layer 21, the first bump pad 71 can be electrically connected to the first conductivity type semiconductor layer 21. Here, the first bump pad 71 may be commonly electrically connected to the first conductivity type semiconductor layer 21, 25 of the first and second light emitting regions C1, C2.

The second-first bump pad 72a may be disposed at the center of the substrate 10 and have a circular shape. Likewise, a plurality of third openings 60a may be disposed under the second-first bump pad 72a such that the second-first bump pad 72a can be connected to the second-first pad metal layer 52a through the third openings 60a. In addition, the second-first pad metal layer 52a may be connected to the ohmic reflective layer 31 of the first light emitting region C1 through the second openings 40b.

The second-second bump pad 72b may be disposed along the third side III of the substrate 10 in the second light emitting region C2 and has both sides extending towards the first side I of the substrate 10 along the second and fourth sides II, IV of the substrate 10. A plurality of third openings 60a may be disposed under the second-second bump pad 72b such that the second-second bump pad 72b can be connected to the second-second pad metal layer 52b through the third openings 60a. Further, the second-second pad metal layer 52b may be connected to the ohmic reflective layer 32 of the second light emitting region C2 through the second openings 40b.

With this structure, the second-first and second-second bump pads 72a, 72b may be electrically connected to the second conductivity type semiconductor layer 25 of the first and second light emitting regions C1, C2.

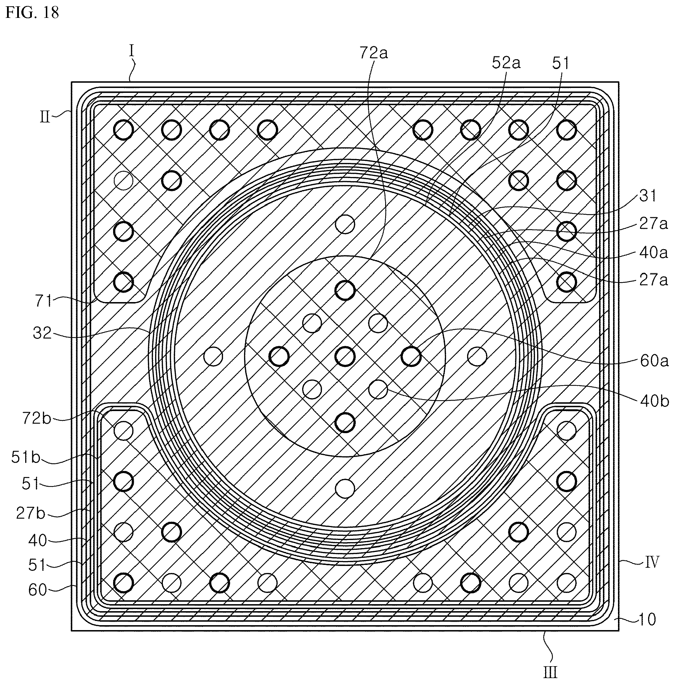

FIG. 18 is a top plan view of a light emitting diode according to yet another exemplary embodiment of the present disclosure. The light emitting diode shown in FIG. 17 is substantially the same as the light emitting diode shown in FIG. 17 excluding the shapes of the mesa trench 27a and the first and second light emitting regions C1, C2. The following description will focus on different features.

The mesa trench 27a is disposed between the first and second light emitting regions C1, C2 and may have a closed loop structure of a circular shape. Accordingly, the first opening 40a of the lower insulation layer 40 in the mesa trench 27a may have a circular shape, like the mesa trench 27a. In addition, the first light emitting region C1 may have a circular shape and the second light emitting region C2 may have a shape surrounding the first light emitting region C1. The first light emitting region C1 having a circular shape may have a larger area than the first light emitting region C1 having a rhombus shape shown in FIG. 17.

Each of the light emitting diodes shown in FIG. 17 and FIG. 18 includes the first and second light emitting regions C1, C2 and an electrical connection between the first and second light emitting regions C1, C2 corresponds to the circuit diagram shown in FIG. 7. That is, the first conductivity type semiconductor layer 21 of the first and second light emitting regions C1, C2 may be electrically connected to one first bump pad 71. Further, the second conductivity type semiconductor layer 25 of the first and second light emitting regions C1, C2 may be electrically connected to each of the second-first and second-second bump pads 72a, 72b.

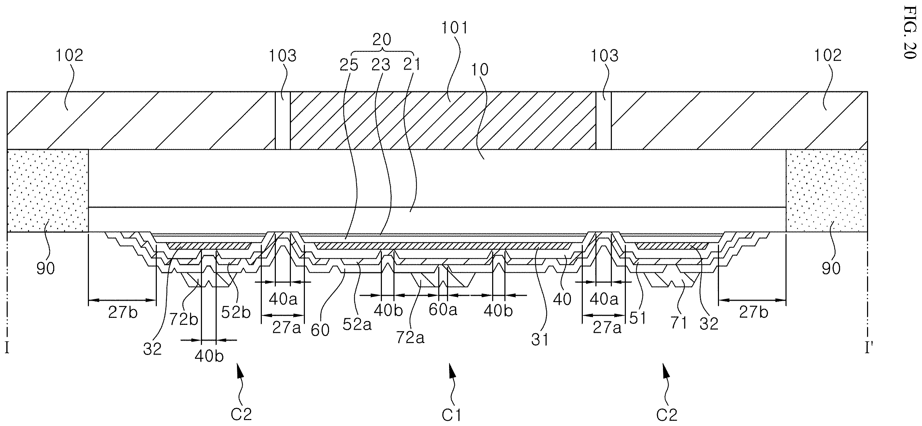

FIG. 19 and FIG. 20 show a light emitting diode package according to one exemplary embodiment of the invention. Specifically, FIG. 19 is a perspective view of the light emitting diode package according to this exemplary embodiment and FIG. 20 is a cross-sectional view taken along line I-I' of FIG. 19.

The light emitting diode package according to this exemplary embodiment includes a light emitting diode, a side reflective layer 90, and a wavelength conversion layer 100.

Referring to FIG. 20, the light emitting diode package includes the light emitting diode shown in FIG. 5. That is, in FIG. 20, the other components of the light emitting diode package excluding the side reflective layer 90 and the wavelength conversion layer 100 are the same as the light emitting diode shown in FIG. 5. Here, the light emitting diode of FIG. 5 in the light emitting diode package of FIG. 19 is provided for illustration only. Thus, it should be understood that the light emitting diode package according to this exemplary embodiment may include the light emitting diode shown in FIG. 1, 5, 8, 13, 14, 15, 16, 17 or 18.

Referring to FIG. 19 to FIG. 20, the side reflective layer 90 may cover upper surfaces of the semiconductor stack 20 and the substrate 10 of the light emitting diode near an edge thereof. The side reflective layer 90 reflects light emitted to a side surface of the semiconductor stack 20 such that the light can be directed to the upper surface of the semiconductor stack 20. The beam angle of light emitted from the light emitting diode package can be restricted by the side reflective layer 90.

The side reflective layer 90 may include a white wall formed of a resin. In the structure wherein the side reflective layer 90 includes the white wall formed of a resin, the side reflective layer 90 may have a predetermined thickness or more in order to improve reliability in blocking or reflection of light traveling towards the semiconductor stack 20. That is, when the side reflective layer 90 has a small thickness, part of light can pass through the side reflective layer 90 formed of a resin. For example, the side reflective layer 90 may have a thickness of 50 µm or more.

The side reflective layer 90 may include a reflective metal layer of Ag or Al, which has high reflectance. The side reflective layer 90 including the reflective metal layer can block and reflect light even with a thickness of several micrometers or less. For example, the side reflective layer 90 may be formed to a thickness of 5 µm or less, specifically 1 µm to 2 µm. Further, since the side reflective layer 90 including the reflective metal layer is formed of a metallic material, the side reflective layer 90 is invulnerable to cracking unlike the white wall formed of a resin.

The wavelength conversion layer 100 covers an upper surface of the light emitting diode, specifically the substrate 10. In this case, the substrate 10 may be a transparent substrate. Specifically, the wavelength conversion layer 100 may be disposed at an opposite side to one surface of the substrate 10 on which the semiconductor stack 20 is formed. Alternatively, the substrate 10 may be omitted and the wavelength conversion layer 100 may cover the semiconductor stack 20. In addition, the wavelength conversion layer 100 may further extend in the lateral direction to cover the side reflective layer 90 surrounding the side surface of the semiconductor stack 20.

The wavelength conversion layer 100 contains phosphors (not shown), which convert wavelengths of light emitted from the light emitting diode. The wavelength conversion layer 100 may have a predetermined thickness or more in order to prevent the phosphors from being exposed to be deformed and/or discolored.

Referring to FIG. 19 and FIG. 20, the wavelength conversion layer 100 includes two regions corresponding to the two light emitting regions C1, C2 of the light emitting diode. That is, the wavelength conversion layer 100 includes a first wavelength conversion layer 101 corresponding to the first light emitting region C1 and a second wavelength conversion layer 102 corresponding to the second light emitting region C2. Accordingly, like the structures of the light emitting regions C1, C2, the first wavelength conversion layer 101 is disposed at the center of the light emitting diode package and the second wavelength conversion layer 102 may be disposed to surround the first wavelength conversion layer 101. That is, the first wavelength conversion layer 101 is disposed on the first light emitting region C1 and the second wavelength conversion layer 102 is disposed on the second light emitting region C2.

The shape and size of the first wavelength conversion layer 101 may be similar to those of the first light emitting region C1. In addition, the shape and size of the second wavelength conversion layer 102 may also be similar to those of the second light emitting region C2. Here, referring again to FIG. 19 and FIG. 20, since the second wavelength conversion layer 102 is also formed on the side reflective layer 90 covering the substrate 10 and the side surface of the semiconductor stack 20, the second wavelength conversion layer 102 may have a larger size than the second light emitting region C2.

Referring to FIG. 19, the first wavelength conversion layer 101 may have a rectangular shape similar to the shape of the first light emitting region C1, and the second wavelength conversion layer 102 may have a rectangular shape surrounding the first wavelength conversion layer 101, like the second light emitting region C2.

In addition, the light emitting regions C1, C2 may have different shapes. For example, referring to FIG. 17, the first light emitting region C1 has a rhombus shape and the second light emitting region C2 has a shape surrounding the first light emitting region C1. In this case, the shape of the first wavelength conversion layer 101 may be a rhombus shape corresponding to the shape of the first light emitting region C1, and the shape of the second wavelength conversion layer 102 may also correspond to the shape of the second light emitting region C2. In another example, referring to FIG. 18, the first light emitting region C1 has a circular shape and the second light emitting region C2 has a shape surrounding the first light emitting region C1. In this case, the shape of the first wavelength conversion layer 101 may be a circular shape corresponding to the shape of the first light emitting region C1, and the shape of the second wavelength conversion layer 102 may also correspond to the shape of the second light emitting region C2.

The wavelength conversion layer 100 may further include a barrier layer 103 interposed between the first and second wavelength conversion layers 101, 102. The barrier layer 103 serves to promote light spreading and mixture of light of different wavelengths emitted from the first wavelength conversion layer 101 and the second wavelength conversion layer 102. The barrier layer 103 can minimize color deviation or rapid change of light at the boundary between the first wavelength conversion layer 101 and the second wavelength conversion layer 102. The barrier layer 103 may be formed of any material so long as the barrier layer can promote light spreading.

The barrier layer 103 may be disposed on the mesa trench 27a in the semiconductor stack 20. That is, corresponding to the structure wherein the first light emitting region C1 is separated from the second light emitting region C2 by the mesa trench 27a, the barrier layer 103 interposed between the first and second wavelength conversion layers 101, 102 can separate the first and second wavelength conversion layers 101, 102 from each other. Accordingly, the first and second wavelength conversion layers 101, 102 may be placed on the first light emitting region C1 and the second light emitting region C2, respectively.

The wavelength conversion layer 100 may be formed into a single sheet by screen printing or the like. For example, after preparation of a sheet for the first wavelength conversion layer 101, the sheet for the first wavelength conversion layer 101 may be partially removed to define a region for the second wavelength conversion layer 102. Then, the second wavelength conversion layer 102 may be formed in a region from which the sheet for the first wavelength conversion layer 101 is partially removed, thereby fabricating a sheet for the wavelength conversion layer 100. Alternatively, a sheet for the second wavelength conversion layer 102 is prepared and partially removed to define a region for the first wavelength conversion layer 101. Then, the first wavelength conversion layer 101 may be formed in a region from which the sheet for the second wavelength conversion layer 102 is partially removed, thereby fabricating a sheet for the wavelength conversion layer 100.

The first wavelength conversion layer 101 includes a first phosphor (not shown) and the second wavelength conversion layer 102 includes a second phosphor (not shown), which is different from the first phosphor. For example, light emitted from the first light emitting region C1 is subjected to wavelength conversion while passing through the first wavelength conversion layer 101, thereby realizing warm white light having a color temperature of 2,700 K to 3,500 K. In addition, light emitted from the second light emitting region C2 is subjected to wavelength conversion while passing through the second wavelength conversion layer 102, thereby realizing cool white light having a color temperature of 5,000 K to 6,500 K, or vice versa.

As described above, the first light emitting region C1 and the second light emitting region C2 can be independently driven, thereby providing different outputs. For example, when light emitted from the first light emitting region C1 is combined with light emitted from the first wavelength conversion layer 101 to realize warm white light and light emitted from the second light emitting region C2 is combined with light emitted from the second wavelength conversion layer 102 to realize cool white light (or vice versa), the color temperature or the correlated color temperature (CCT) of light realized by the light emitting diode can be regulated by controlling input voltage and/or current to the first light emitting region C1 and the second light emitting region C2.

For example, when power is applied to the first light emitting region C1 and is not applied to the second light emitting region C2, the light emitting diode can emit white light having a color temperature of 2,700 K to 3,500 K. Conversely, when power is applied to the second light emitting region C2 and is not applied to the first light emitting region C1, the light emitting diode can emit white light having a color temperature of 5,000 K to 6,500 K. When power is applied to both the first light emitting region C1 and the second light emitting region C2, light emitted from the light emitting diode may have a color temperature corresponding to the middle range between warm white and cool white. Here, the structure wherein the second light emitting region C2 surrounds the first light emitting region C1 facilitates efficient mixing of the two colors.

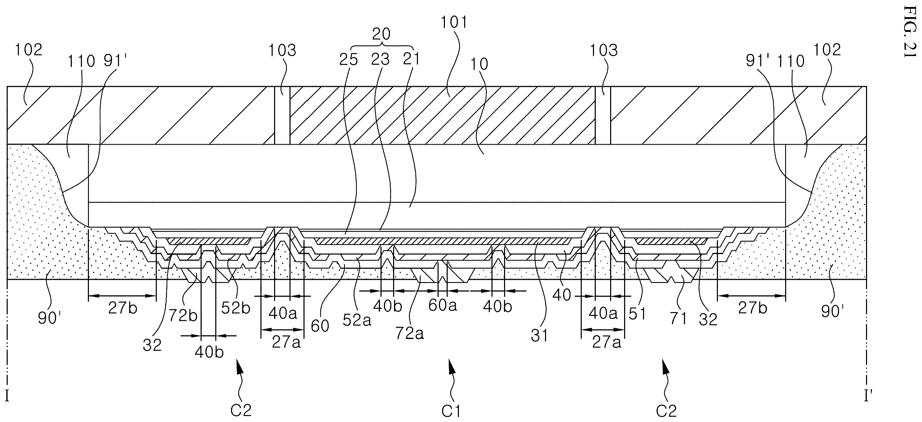

FIG. 21 is a cross-sectional view taken along line I-I' of FIG. 19, in which a side reflective layer 90' has a different shape than the side reflective layer 90 shown in FIG. 20. In addition, the light emitting diode package shown in FIG. 21 may further include a filling material 110.

Referring to FIG. 21, the side reflective layer 90' may cover the substrate 10 and the side surface of the semiconductor stack 20 of the light emitting diode. In addition, the side reflective layer 90' may cover a lower surface of the light emitting diode. In this structure, the first bump pad 71 and the second bump pads 72a, 72b may be exposed on the lower surface of the light emitting diode.

The side reflective layer 90' may include a slanted surface 91' on the side surface of the light emitting diode. The slanted surface 91' of the side reflective layer 90' can more efficiently reflect light emitted through the side surface of the semiconductor stack 20 in the upward direction of the light emitting diode. With the structure wherein the side layer 90' includes the slanted surface 91', the light emitting diode can provide enhanced output.

As the side reflective layer 90' includes the slanted surface 91', the side reflective layer 90' may be separated from the substrate 10 and the semiconductor stack 20 of the light emitting diode and the filling material 110 may be disposed to fill the space therebetween. Here, it is necessary for the filling material 110 to minimize absorption of light emitted from the semiconductor stack 20. Accordingly, it is desirable that the filling material 110 be formed of a transparent material. For example, the filling material 110 may be formed of a transparent resin.

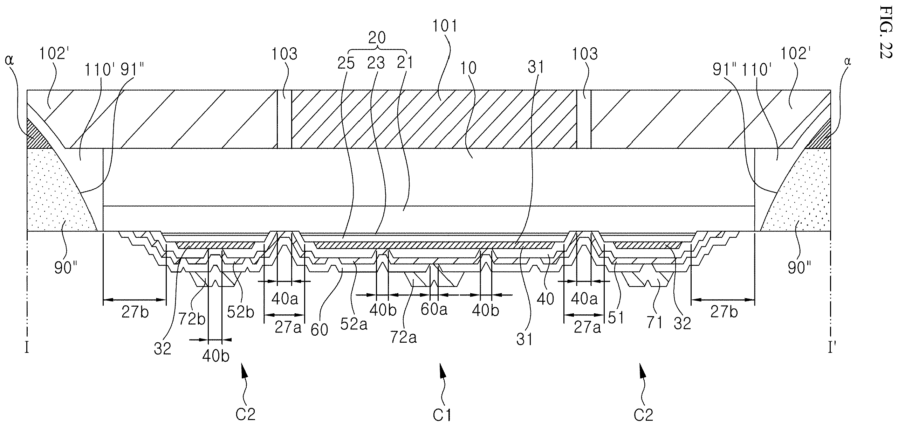

FIG. 22 is a cross-sectional view taken along line I-I' of FIG. 19, in which a side reflective layer 90", a filling material 110' and a second wavelength conversion layer 102' have different shapes than those shown in FIG. 21.

Referring to FIG. 22, the side reflective layer 90" may cover the substrate 10 and the side surface of the semiconductor stack 20 of the light emitting diode and may include a slanted surface 91". According to this exemplary embodiment, the side reflective layer 90" may have a greater height than the side reflective layer 90' shown in FIG. 21. That is, the side reflective layer 90" may include a region α at a higher location than the substrate 10 of the light emitting diode.

The region α of the side reflective layer 90" placed at a higher location than the substrate 10 of the light emitting diode can further restrict the beam angle of light emitted from the light emitting diode package. That is, the region α can reflect light emitted outside the second wavelength conversion layer 102' through the substrate, whereby the beam angle of the light emitting diode package can be further restricted.

As the side reflective layer 90" includes the region α, the filling material 110' may further extend along the region α. In addition, as the side reflective layer 90" includes the region α, an outermost lower end of the second wavelength conversion layer 102' may be partially removed.

## Claims

1. A light emitting diode package comprising:
a light emitting diode; and
a wavelength conversion layer (100) covering an upper surface of the light emitting diode;
wherein the light emitting diode comprises:
a first light emitting region (C1) and a second light emitting region (C2), each comprising a first conductivity type semiconductor layer (21), a second conductivity type semiconductor layer (25) and an active layer (23) interposed between the first conductivity type semiconductor layer (21) and the second conductivity type semiconductor layer (25);
an ohmic reflective layer (31, 32) disposed on the second conductivity type semiconductor layer (25) of each of the first and second light emitting regions (C1, C2);
a first pad metal layer (51) separated from the ohmic reflective layer (31, 32) and electrically connected to the first conductivity type semiconductor layer (21) of each of the first and second light emitting regions (C1, C2); and
a mesa trench (27a) disposed between the first light emitting region (C1) and the second light emitting region (C2) and exposing the first conductivity type semiconductor layers (21),
wherein the mesa trench (27a) has a closed loop structure surrounding the first light emitting region (C1) and is surrounded by the second light emitting region (C2);
wherein the second light emitting region (C2) surrounds the first light emitting region (C1);
wherein the first light emitting region (C1) and the second light emitting region (C2) are independently driven;
wherein the wavelength conversion layer (100) comprises a first wavelength conversion layer (101) corresponding to the first light emitting region (C1) and a second wavelength conversion layer (102) corresponding to the second light emitting region (C2);
wherein the first wavelength conversion layer (101) and the second wavelength conversion layer (102) have different combinations of phosphors;
**characterised in that**
the light emitting diode package further comprises a side reflective layer (90) surrounding a side surface of the light emitting diode; and **in that**
the light emitting diode further comprises a lower insulation layer (40) covering the first and second light emitting regions (C1, C2) and the ohmic reflective layers (31, 32),
wherein the first pad metal layer (51) is disposed on the lower insulation layer (40),
wherein the lower insulation layer (40) comprises a first opening (40a) exposing the first conductivity type semiconductor layer (21) of the second light emitting region (C2) exposed through the mesa trench (27a) and second openings (40b) exposing the ohmic reflective layer (31, 32), and
wherein the first pad metal layer (51) is connected to said exposed first conductivity type semiconductor layer (21) through the first opening (40a).

2. The light emitting diode package according to claim 1, further comprising:
a second pad metal layer (52a, 52b) disposed on the lower insulation layer (40) and connected to the ohmic reflective layer (31, 32) through the second openings (40b),
wherein the second pad metal layer (52a, 52b) comprises:
a second-first pad metal layer (51) connected to the ohmic reflective layer (31, 32) disposed in the first light emitting region (C1) and exposed through the second openings (40b); and
a second-second pad metal layer (52a, 52b) connected to the ohmic reflective layer (31, 32) disposed in the second light emitting region (C2) exposed through the second openings (40b).

3. The light emitting diode package according to claim 2, further comprising: an upper insulation layer (60) covering the first and second pad metal layers (51, 52a, 52b)s and comprising third openings (60a) exposing the first and second pad metal layers (51, 52a, 52b).

4. The light emitting diode package according to claim 3, further comprising:
a first bump pad (71) connected to the first pad metal layer (51) through at least one third opening (60a);
a second-first bump pad (71) connected to the second-first pad metal layer (51) through at least one third opening (60a); and
a second-second bump pad (52a, 52b) connected to the second-second pad metal layer (52a, 52b) through at least one third opening (60a).

5. The light emitting diode package according to claim 1, further comprising:
a substrate (10) disposed under the first conductivity type semiconductor layer (21); and
an isolation trench (80) interposed between the first light emitting region (C1) and the second light emitting region (C2) and exposing the substrate (10),
wherein the isolation trench (80) comprises a closed loop structure surrounding the first light emitting region (C1) and surrounded by the second light emitting region (C2).

6. The light emitting diode package according to claim 5, further comprising:
a lower insulation layer (40) covering the first and second light emitting regions (C2), the ohmic reflective layer (31, 32), and the substrate (10) exposed through the isolation trench (80),
wherein each of the first and second light emitting regions (C2) comprises a mesa etching region exposing the first conductivity type semiconductor layer (21)

7. The light emitting diode package according to claim 6, wherein the lower insulation layer (40) comprises at least one first opening (40a) exposing the first conductivity type semiconductor layer (21) exposed in the mesa etching region and at least one second opening exposing the ohmic reflective layer (31, 32) in each of the first and second light emitting regions (C2); and
wherein the first pad metal layer (51) comprises:
a first-first pad metal layer (51) connected to the first conductivity type semiconductor layer (21) of the first light emitting region (C1) through the at least one first opening (40a); and
a first-second pad metal layer (52a, 52b) connected to the first conductivity type semiconductor layer (21) of the second light emitting region (C2) through the at least one first opening (40a).

8. The light emitting diode package according to claim 7, further comprising:
a second pad metal layer (52a, 52b) disposed on the lower insulation layer (40) and connected to the ohmic reflective layer (31, 32) through the at least one second opening,
wherein the second pad metal layer (52a, 52b) is commonly connected to the ohmic reflective layer (31, 32) of each of the first and second light emitting regions (C2) through the at least one second opening.

9. The light emitting diode package according to claim 8, further comprising:
a upper insulation layer (60) covering the first and second pad metal layers (52a, 52b),
wherein the upper insulation layer (60) comprises third openings (60a) exposing the first and second pad metal layers (52a, 52b).

10. The light emitting diode package according to claim 9, further comprising:
a first-first bump pad (71) connected to the first-first pad metal layer (51) exposed through the third openings (60a);
a first-second bump pad (52a, 52b) connected to the first-second pad metal layer (52a, 52b) exposed through the third openings (60a); and
a second bump pad (52a, 52b) connected to the second pad metal layer (52a, 52b) exposed through the third openings (60a).

11. The light emitting diode package of claim 1 further comprising:
a barrier layer (103) interposed between the first and second wavelength conversion layers (101, 102) and corresponding to the structure wherein the first light emitting region (C1) is separated from the second light emitting region (C2) by the mesa trench (27a).

12. The light emitting diode package according to claim 1, wherein the mesa trench (27a) has a rectangular shape with rounded corners and an indented portion formed at the middle of a rectangular shape and extending from one side of the rectangular shape to an opposite side thereof.

## Patentansprüche

1. Leuchtdiodenanordnung, umfassend:
eine Leuchtdiode; und
eine wellenlängenumwandelnde Schicht (100), die eine obenliegende Fläche der Leuchtdiode bedeckt;
wobei die Leuchtdiode Folgendes umfasst:
eine erste lichtemittierende Region (C1) und eine zweite lichtemittierende Region (C2), wobei jede davon eine Halbleiterschicht (21) von einem ersten Leitfähigkeitstyp und eine Halbleiterschicht (25) von einem zweiten Leitfähigkeitstyp sowie eine Wirkschicht (23) umfasst, die zwischen der Halbleiterschicht (21) des ersten Leitfähigkeitstyps und der Halbleiterschicht (25) des zweiten Leitfähigkeitstyps angeordnet ist;
eine ohmsche reflektierende Schicht (31, 32), die auf der Halbleiterschicht (25) des zweiten Leitfähigkeitstyps jeder der ersten und zweiten lichtemittierenden Regionen (C1, C2) angeordnet ist;
eine erste mattenartige Metallschicht (51), die von der ohmschen reflektierenden Schicht (31, 32) getrennt ist und
elektrisch mit der Halbleiterschicht (21) des ersten Leitfähigkeitstyps jeder der ersten und zweiten lichtemittierenden Regionen (C1, C2) verbunden ist; und
einen Mesa-Graben (27a), der zwischen der ersten lichtemittierenden Region (C1) und der zweiten lichtemittierenden Region (C2) angeordnet ist und die Halbleiterschichten (21) des ersten Leitfähigkeitstyps offenlegt, wobei der Mesa-Graben (27a) eine geschlossene Schleifenstruktur aufweist, welche die erste lichtemittierende Region (C1) umgibt und von der zweiten lichtemittierenden Region (C2) umgeben ist;
wobei die zweite lichtemittierende Region (C2) die erste lichtemittierende Region (C1) umgibt;
wobei die erste lichtemittierende Region (C1) und die zweite lichtemittierende Region (C2) unabhängig voneinander betrieben werden;
wobei die wellenlängenumwandelnde Schicht (100) eine erste wellenlängenumwandelnde Schicht (101), die der ersten lichtemittierenden Region (C1) entspricht, und eine zweite wellenlängenumwandelnde Schicht (102) umfasst, die der zweiten lichtemittierenden Region (C2) entspricht;
wobei die erste wellenlängenumwandelnde Schicht (101) und
die zweite wellenlängenumwandelnde Schicht (102) unterschiedliche Kombinationen von Leuchtstoffen aufweisen;
**dadurch gekennzeichnet, dass** die Leuchtdiodenanordnung ferner eine seitliche reflektierende Schicht (90) umfasst,
die eine seitliche Fläche der Leuchtdiode umgibt; und
dadurch, dass
die Leuchtdiode ferner eine untenliegende Isolierschicht (40) umfasst, welche die erste und die zweite lichtemittierende Region (C1, C2) und die ohmschen reflektierenden Schichten (31, 32) bedeckt,
wobei die erste mattenartige Metallschicht (51) auf der untenliegenden Isolierschicht (40) angeordnet ist,
wobei die unterliegende Isolierschicht (40) eine erste Öffnung (40a), welche die Halbleiterschicht (21) des ersten Leitfähigkeitstyps offenlegt, die der zweiten lichtemittierenden Region (C2) angehört und durch den Mesa-Graben (27a) offengelegt wird, sowie zweite Öffnungen (40b) umfasst, welche die ohmsche reflektierende Schicht (31, 32) offenlegen, und
wobei die erste mattenartige Metallschicht (51) durch die erste Öffnung (40a) mit der offengelegten Halbleiterschicht (21) des ersten Leitfähigkeitstyps verbunden ist.

2. Leuchtdiodenanordnung nach Anspruch 1, ferner umfassend:
eine zweite mattenartige Metallschicht (52a, 52b), die auf der untenliegenden Isolierschicht (40) angeordnet ist und
durch die zweiten Öffnungen (40b) mit der ohmschen reflektierenden Schicht (31, 32) verbunden ist,
wobei die zweite mattenartige Metallschicht (52a, 52b) Folgendes umfasst:
eine zweit-erste mattenartige Metallschicht (51), die mit der ohmschen reflektierenden Schicht (31, 32) verbunden ist, die in der ersten lichtemittierenden Region (C1) angeordnet und durch die zweiten Öffnungen (40b) offengelegt ist; und
eine zweit-zweite mattenartige Metallschicht (52a, 52b), die mit der ohmschen reflektierenden Schicht (31, 32) verbunden ist, die in der zweiten lichtemittierenden Region (C2) angeordnet, die durch die zweiten Öffnungen (40b) offengelegt ist.

3. Leuchtdiodenanordnung nach Anspruch 2, ferner umfassend:
eine obenliegende Isolierschicht (60), welche die erste und die zweite mattenartige Metallschicht (51, 52a, 52b) bedeckt und dritte Öffnungen (60a) umfasst, welche die erste und die zweite mattenartige Metallschicht (51, 52a, 52b) offenlegen.

4. Leuchtdiodenanordnung nach Anspruch 3, ferner umfassend:
eine erste Hügelmatte (71), die durch mindestens eine dritte Öffnung (60a) mit der ersten mattenartigen Metallschicht (51) verbunden ist;
eine zweit-erste Hügelmatte (71), die durch mindestens eine dritte Öffnung (60a) mit der zweit-ersten mattenartigen Metallschicht (51) verbunden ist; und
eine zweit-zweite Hügelmatte (52a, 52b), die durch mindestens eine dritte Öffnung (60a) mit der zweit-zweiten mattenartigen Metallschicht (52a, 52b) verbunden ist

5. Leuchtdiodenanordnung nach Anspruch 1, ferner umfassend:
ein Substrat (10), das unter der Halbleiterschicht (21) des ersten Leitfähigkeitstyps angeordnet ist; und
einen Isolationsgraben (80), der zwischen der ersten lichtemittierenden Region (C1) und der zweiten lichtemittierenden Region (C2) angeordnet ist und das Substrat (10) offenlegt.
wobei der Isolationsgraben (80) eine geschlossene Schleifenstruktur umfasst, welche die erste lichtemittierende Region (C1) umgibt und von der zweiten lichtemittierenden Region (C2) umgeben ist.

6. Leuchtdiodenanordnung nach Anspruch 5, ferner umfassend:
eine untenliegende Isolierschicht (40), welche die erste und die zweite lichtemittierende Region (C2), die ohmsche reflektierende Schicht (31, 32) und das Substrat (10) bedeckt, das durch den Isolationsgraben (80) offengelegt wird,
wobei jede der ersten und zweiten lichtemittierenden Regionen (C2) eine Mesa-Ätzregion umfasst, welche die Halbleiterschicht (21) des ersten Leitfähigkeitstyps offenlegt.

7. Leuchtdiodenanordnung nach Anspruch 6, wobei die untenliegende Isolierschicht (40) mindestens eine erste Öffnung (40a), welche die Halbleiterschicht (21) des ersten Leitfähigkeitstyps offenlegt, die in der Mesa-Ätzregion offengelegt ist, und mindestens eine zweite Öffnung umfasst, welche die ohmsche reflektierende Schicht (31, 32) in jeder der ersten und zweiten lichtemittierenden Regionen (C2) offenlegt.
wobei die erste mattenartige Metallschicht (51) Folgendes umfasst:
eine erst-erste mattenartige Metallschicht (51), die durch die mindestens eine erste Öffnung (40a) mit der Halbleiterschicht (21) des ersten Leitfähigkeitstyps der ersten lichtemittierenden Region (C1) verbunden ist; und
eine erst-zweite mattenartige Metallschicht (52a, 52b), die durch die mindestens eine erste Öffnung (40a) mit der Halbleiterschicht (21) des ersten Leitfähigkeitstyps der zweiten lichtemittierenden Region (C2) verbunden ist.

8. Leuchtdiodenanordnung nach Anspruch 7, ferner umfassend:
eine zweite mattenartige Metallschicht (52a, 52b), die auf der untenliegenden Isolierschicht (40) angeordnet ist und durch die mindestens eine zweite Öffnung mit der ohmschen reflektierenden Schicht (31, 32) verbunden ist,
wobei die zweite mattenartige Metallschicht (52a, 52b) gemeinsam durch die mindestens eine zweite Öffnung mit der jeweiligen ohmschen reflektierenden Schicht (31, 32) der ersten und zweiten lichtemittierenden Regionen (C2) verbunden ist.

9. Leuchtdiodenanordnung nach Anspruch 8, ferner umfassend:
eine obenliegende Isolierschicht (60), welche die erste und die zweite mattenartige Metallschicht (52a, 52b) bedeckt, wobei die obenliegende Isolierschicht (60) dritte Öffnungen (60a) umfasst, welche die erste und die zweite Metallschicht (52a, 52b) offenlegen.

10. Leuchtdiodenanordnung nach Anspruch 9, ferner umfassend:
eine erst-erste Hügelmatte (71), die mit der erst-ersten mattenartigen Metallschicht (51) verbunden ist, die durch die dritten Öffnungen (60a) offengelegt ist;
eine erst-zweite Hügelmatte (52a, 52b), die mit der erstzweiten mattenartigen Metallschicht (52a, 52b) verbunden ist, die durch die dritten Öffnungen (60a) offengelegt ist; und
eine zweite Hügelmatte (52a, 52b), die mit der zweiten mattenartigen Metallschicht (52a, 52b) verbunden ist, die durch die dritten Öffnungen (60a) offengelegt ist.

11. Leuchtdiodenanordnung nach Anspruch 1, ferner umfassend:
eine Sperrschicht (103), die zwischen der ersten und der zweiten wellenlängenumwandelnden Schicht (101, 102) angeordnet ist und der Struktur entspricht, in der die erste lichtemittierende Region (C1) durch den Mesa-Graben (27a) von der zweiten lichtemittierenden Region (C2) getrennt ist.

12. Leuchtdiodenanordnung nach Anspruch 1, wobei der Mesa-Graben (27a) eine rechteckige Form mit abgerundeten Ecken und einem eingekerbten Teilbereich aufweist, der in der Mitte der rechteckigen Form ausgebildet ist und sich von einer Seite der rechteckigen Form zu einer gegenüberliegenden Seite derselben erstreckt.

## Revendications

1. Boîtier de diode électroluminescente comprenant :
une diode électroluminescente ; et
une couche de conversion de longueur d'onde (100) recouvrant une surface supérieure de la diode électroluminescente ;
dans lequel la diode électroluminescente comprend :
une première région électroluminescente (C1) et une seconde région électroluminescente (C2) comprenant chacune une couche semi-conductrice à premier type de conductivité (21),
une couche semi-conductrice à second type de conductivité (25) et une couche active (23) intercalée entre la couche semi-conductrice à premier type de conductivité (21) et la couche semi-conductrice à second type de conductivité (25) ;
une couche réfléchissante ohmique (31, 32) disposée sur la couche semi-conductrice à second type de conductivité (25) de chacune des première et seconde régions électroluminescentes (C1, C2) ;
une première couche métallique formant pastille (51) séparée de la couche réfléchissante ohmique (31, 32) et électriquement connectée à la couche semi-conductrice à premier type de conductivité (21) de chacune des première et seconde régions électroluminescentes (C1, C2) ; et
une tranchée de mésa (27a) disposée entre la première région électroluminescente (C1) et la seconde région électroluminescente (C2) et faisant apparaître les couches semi-conductrices à premier type de conductivité (21),
dans lequel la tranchée de mésa (27a) possède une structure de boucle fermée entourant la première région électroluminescente (C1) et est entourée de la seconde région électroluminescente (C2) ;
dans lequel la seconde région électroluminescente (C2) entoure la première région électroluminescente (C1) ;
dans lequel la première région électroluminescente (C1) et la seconde région électroluminescente (C2) sont attaquées de façon indépendante ;
dans lequel la couche de conversion de longueur d'onde (100) comprend une première couche de conversion de longueur d'onde (101) correspondant à la première région électroluminescente (C1) et une seconde couche de conversion de longueur d'onde (102) correspondant à la seconde région électroluminescente (C2) ;
dans lequel la première couche de conversion de longueur d'onde (101) et la seconde couche de conversion de longueur d'onde (102) ont des combinaisons différentes de luminophores ;
**caractérisé en ce que** :
le boîtier de diode électroluminescente comprend en outre une couche réfléchissante latérale (90) entourant une surface latérale de la diode électroluminescente ; et **en ce que** :
la diode électroluminescente comprend en outre une couche d'isolation inférieure (40) recouvrant les première et
seconde régions électroluminescentes (C1, C2) et les couches réfléchissantes ohmiques (31, 32),
dans lequel la première couche métallique formant pastille (51) est disposée sur la couche d'isolation inférieure (40),
dans lequel la couche d'isolation inférieure (40) comprend une première ouverture (40a) faisant apparaître la couche semi-conductrice à premier type de conductivité (21) de la seconde région électroluminescente (C2) rendue apparente à travers la tranchée de mésa (27a) et des secondes ouvertures (40b) faisant apparaître la couche réfléchissante ohmique (31, 32), et
dans lequel la première couche métallique formant pastille (51) est connectée à ladite couche semi-conductrice à premier type de conductivité rendue apparente (21) à travers la première ouverture (40a).

2. Boîtier de diode électroluminescente selon la revendication 1, comprenant en outre :
une seconde couche métallique formant pastille (52a, 52b) disposée sur la couche d'isolation inférieure (40) et
connectée à la couche réfléchissante ohmique (31, 32) à travers les secondes ouvertures (40b),
dans lequel la seconde couche métallique formant pastille (52a, 52b) comprend :
une seconde première couche métallique formant pastille (51) connectée à la couche réfléchissante ohmique (31, 32) disposée dans la première région électroluminescente (C1) et rendue apparente à travers les secondes ouvertures (40b) ; et
une seconde seconde couche métallique formant pastille (52a, 52b) connectée à la couche réfléchissante ohmique (31, 32) disposée dans la seconde région électroluminescente (C2) rendue apparente à travers les secondes ouvertures (40b).

3. Boîtier de diode électroluminescente selon la revendication 2, comprenant en outre :
une couche d'isolation supérieure (60) recouvrant les premières et secondes couches métalliques formant pastilles (51, 52a, 52b) et comprenant des troisièmes ouvertures (60a) faisant apparaître les premières et secondes couches métalliques formant pastilles (51, 52a, 52b) .

4. Boîtier de diode électroluminescente selon la revendication 3, comprenant en outre :
une première pastille formant bosse (71) connectée à la première couche métallique formant pastille (51) à travers au moins une troisième ouverture (60a) ;
une seconde première pastille formant bosse (71) connectée à la seconde première couche métallique formant pastille (51) à travers au moins une troisième ouverture (60a) ; et
une seconde seconde pastille formant bosse (52a, 52b) connectée à la seconde seconde couche métallique formant pastille (52a, 52b) à travers au moins une troisième ouverture (60a).

5. Boîtier de diode électroluminescente selon la revendication 1, comprenant en outre :
un substrat (10) disposé sous la couche semi-conductrice à premier type de conductivité (21) ; et
une tranchée d'isolation (80) disposée entre la première région électroluminescente (C1) et la seconde région électroluminescente (C2) et faisant apparaître le substrat (10),
dans lequel la tranchée d'isolation (80) possède une structure de boucle fermée entourant la première région électroluminescente (C1) et entourée de la seconde région électroluminescente (C2).

6. Boîtier de diode électroluminescente selon la revendication 5, comprenant en outre :
une couche d'isolation inférieure (40) recouvrant les première et seconde régions électroluminescentes (C2), la couche réfléchissante ohmique (31, 32) et le substrat (10) rendu apparent à travers la tranchée d'isolation (80),
dans lequel chacune des première et seconde régions électroluminescentes (C2) comprend une région de gravure mésa faisant apparaître la couche semi-conductrice à premier type de conductivité (21).

7. Boîtier de diode électroluminescente selon la revendication 6, dans lequel la couche d'isolation inférieure (40) comprend au moins une première ouverture (40a) faisant apparaître la couche semi-conductrice à premier type de conductivité (21) rendue apparente dans la région de gravure mésa et au moins une seconde ouverture faisant apparaître la couche réfléchissante ohmique (31, 32) dans chacune des première et seconde régions électroluminescentes (C2) ; et
dans lequel la première couche métallique formant pastille (51) comprend :
une première première couche métallique formant pastille (51) connectée à la couche semi-conductrice à premier type de conductivité (21) de la première région électroluminescente (C1) à travers l'au moins une première ouverture (40a) ; et
une première seconde couche métallique formant pastille (52a, 52b) connectée à la couche semi-conductrice à premier type de conductivité (21) de la seconde région électroluminescente (C2) à travers l'au moins une première ouverture (40a).

8. Boîtier de diode électroluminescente selon la revendication 7, comprenant en outre :
une seconde couche métallique formant pastille (52a, 52b) disposée sur la couche d'isolation inférieure (40) et
connectée à la couche réfléchissante ohmique (31, 32) à travers l'au moins une seconde ouverture,
dans lequel la seconde couche métallique formant pastille (52a, 52b) est connectée conjointement à la couche réfléchissante ohmique (31, 32) de chacune des première et
seconde régions électroluminescentes (C2) à travers l'au moins une seconde ouverture.

9. Boîtier de diode électroluminescente selon la revendication 8, comprenant en outre :
une couche d'isolation supérieure (60) recouvrant les première et seconde couches métalliques formant pastilles (52a, 52b),
dans lequel la couche d'isolation supérieure (60) comprend des troisièmes ouvertures (60a) faisant apparaître les première et seconde couches métalliques formant pastilles (52a, 52b).

10. Boîtier de diode électroluminescente selon la revendication 9, comprenant en outre :
une première première pastille formant bosse (71) connectée à la première première couche métallique formant pastille (51) rendue apparente à travers les troisièmes ouvertures (60a) ;
une première seconde pastille formant bosse (52a, 52b) connectée à la première seconde couche métallique formant pastille (52a, 52b) rendue apparente à travers les troisièmes ouvertures (60a) ; et
une seconde pastille formant bosse (52a, 52b) connectée à la seconde couche métallique formant pastille (52a, 52b) rendue apparente à travers les troisièmes ouvertures (60a).

11. Boîtier de diode électroluminescente selon la revendication 1, comprenant en outre :
une couche barrière (103) intercalée entre les première et seconde couches de conversion de longueur d'onde (101, 102) et correspondant à la structure dans laquelle la première région électroluminescente (C1) est séparée de la seconde région électroluminescente (C2) par la tranchée de mésa (27a).

12. Boîtier de diode électroluminescente selon la revendication 1, dans lequel la tranchée de mésa (27a) présente une forme rectangulaire à coins arrondis et comporte une partie en retrait formée au milieu d'une forme rectangulaire et s'étendant d'un côté de la forme rectangulaire à un côté opposé de celle-ci.
